# EUROPEAN PATENT APPLICATION

(11) **EP 2 060 994 A1**
(43) Date of publication of application: **20.05.2009**
(21) Application number: 07740576.9
(22) Date of filing: 30.03.2007
(51) Int. Cl.: G06K 17/00, G06K 19/077

(54) **IC CARD AND IC CARD SOCKET**

(30) Priority: 27.09.2006 JP 2006262776
(71) Applicant: Renesas Technology Corp., Tokyo 100-6334 (JP)
(72) Inventor: NISHIZAWA, Hirotaka, Tokyo 100-6334 (JP); OSAKO, Junichiro, Tokyo 100-6334 (JP); IWASAKI, Hironori, Tokyo 163-1331 (JP); KOIKE, Hideo, Tokyo 100-6334 (JP); WADA, Tamaki, Tokyo 100-6334 (JP); TOTSUKA, Takashi, Tokyo 100-6334 (JP)
(74) Representative: Calderbank, Thomas Roger
(86) International application number: PCT/JP2007/057140
(87) International publication number: WO 2008/038428

(57) **Abstract**

A technique for an IC capable of achieving the large expandability of the memory capacity, a memory capacity and cost burden in accordance with the requirements of users is provided. The IC card of the present invention is a flash memory card 306 mounted with a flash memory, **characterized in that** the flash memory card 306 can be inserted into a Plug-in SIM adaptor 305a and/or a mini UICC adaptor 305b each mounted with a secure IC, the flash memory card 306 is inserted into the Plug-in SIM adaptor 305a or the mini UICC adaptor 305b, thereby operating as a SIM attached with an expansion memory or a mini UICC attached with an expansion memory, and the flash memory card 306 can be physically removed from the Plug-in SIM adaptor 305a or the mini UICC adaptor 305b.

## Description

### TECHNICAL FIELD

The present invention relates to an IC card, and more particularly to a technique effectively applied to an IC card which mounts a thin memory card in a removable manner and attaches importance to interchangeability.

### BACKGROUND ART

As the techniques examined by the present inventors, for example, the following technique is conceivable in the IC card.

For example, as one type of the IC card, there is a card referred to as a SIM card (Subscriber Identity Module Card). The SIM card is an IC card recorded with subscriber information, which is inserted into a mobile phone and used to identify a user. Even for the phone of a different system, the phone number and billing information can be directly taken over by displacing and using a common IC card, and this is realized as a GSM card in a GSM mobile phone. The outer dimensions of the SIM card use an ID-000 format of 15 mm x 25 mm x 0.76 mm. More specifically, the planar dimensions are 15 mm x 25 mm and the thickness is approximately 0.76 mm. On the surface thereof, external interface terminals (ISO7816 interface terminals) defined by the standards of the terminal position and the function of ISO/IEC7816-3 are arranged.

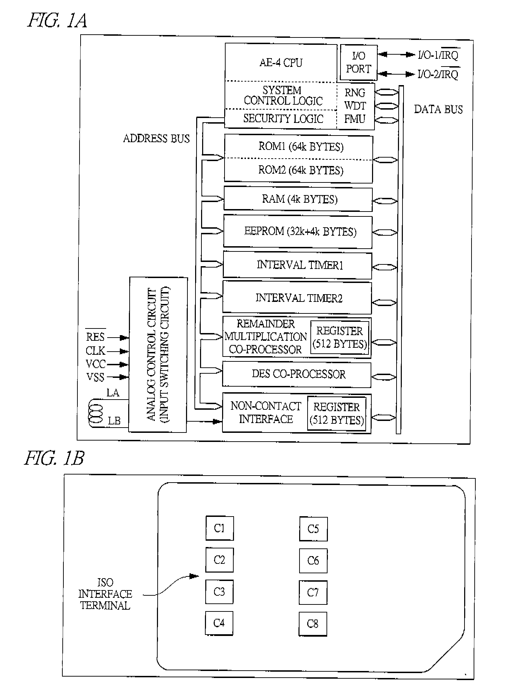

FIG. 1A is a block diagram showing the configuration of a smart card of Plug-in SIM (ID-000) examined as a premise of the present invention, and FIG. 1B is a view showing terminal allocation according to the ISO7816.

As shown in FIG. 1A, the SIM card is mounted with a microcomputer (SIC) including CPU, ROM, RAM, EEPROM and the like as a secure IC chip. An antenna coil such as LA and LB and a non-contact interface are optional and can be omitted.

As shown in FIG. 1B, eight pieces of the ISO7816 interface terminals from C1 to C8 are arranged on a rear side of the SIM card, and the ISO7816 terminals are allocated so that C1 is VCC (+ power supply), C2 is RES (reset), C3 is CLK (clock), C4, C6 and C8 are RSV (reserve), C5 is VSS (ground), and C7 is I/O (input and output). Here, the reserve terminals can be used as expansion terminals for the realization of a USB interface, the realization of MMC and serial interface or the realization of non-contact (contactless card) function.

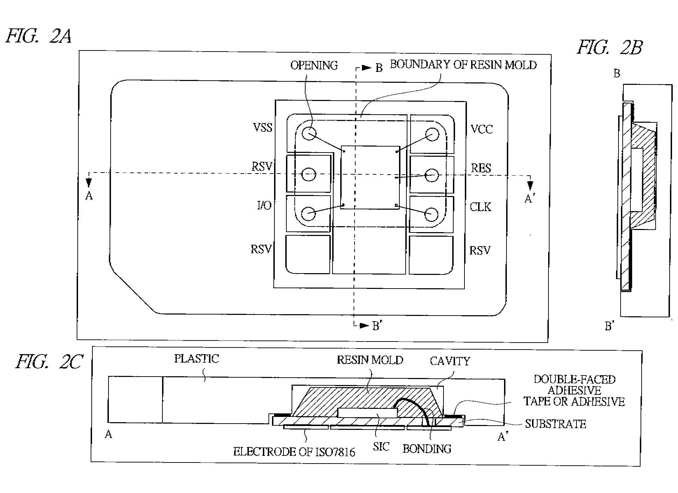

FIG. 2A is a structural drawing viewed from a SIC chip mounting side (opposite side of FIG. 1B) of the SIM card examined as a premise of the present invention. FIG. 2B is a cross sectional view along the line B-B' of FIG. 2A, and FIG. 2C is a cross sectional view along the line A-A' of FIG. 2A. Note that, in FIG. 2A, dashed line illustration is applied in order to clarify the corresponding relation of the ISO7816 interface terminals C1 to C8 shown in FIG. 1B, the grooves of cavities, and the position where the SIC chip is disposed.

As shown in FIG. 2B and FIG. 2C, a SIC chip is mounted on a substrate having electrodes of ISO7816 (ISO7816 interface terminals) on its rear surface, and the terminals of the SIC chip and the ISO7816 electrodes are wire-bonded through openings on the substrate. The SIC chip on the substrate is sealed by resin mold, and the plastic forming the outer shape of the card and the substrate are connected by a double-faced adhesive tape. In FIG. 2B and FIG. 2C, the RSV terminals are not connected to the terminals of the SIC chip.

As the technique regarding such an IC card, for example, the technique disclosed in Patent Document 1 can be cited.

The patent Document 1 discloses an IC card module including a microcomputer, a memory card controller, and a flash memory. In this IC card module, a plurality of first external connection terminals and a plurality of second external connection terminals are exposed on one surface of a card substrate, and the IC card module includes a microcomputer connected to the first external connection terminals, a memory card controller connected to the second external connection terminals, and a flash memory connected to the memory card controller. The shape of the card substrate and the arrangement of the first external connection terminals conform to the standards of the Plug-in UICC (Universal Integrated Circuit Card) of ETSI TS 102 221 V4.4.0(2001-10) or have interchangeability. The second external connection terminals are arranged outside the minimum range of the terminal arrangement according to the standards of the first external connection terminals, and signal terminals of the first and second external connection terminals are electrically separated from each other. By this means, the interchangeability with the SIM card and the adaptation to high speed memory access are realized.

Further, Non-Patent Document 1 discloses the technique regarding a common smart card.
[Patent Document 1] Japanese Patent Application Laid-Open Publication No. 2005-322109
[Non-Patent Document 1] W. Raukl & W. Effing, "Smart Card Handbook" Second Edition, WILEY, P. 27-31

### DISCLOSURE OF THE INVENTION

### Problem to be Solved by the Invention

Now, as a result of the examination regarding the technique of such an IC card by the present inventors, the followings have been revealed.

For example, though the SIC chip is mounted with a non-volatile memory such as an EEPROM, a memory capacity becomes insufficient depending on the way of use. The memory capacity may be expanded by mounting a flash memory as an expansion memory like in the Patent Document 1. However, to mount the flash memory having a fixed memory capacity uniformly for all the users leads to an enormous cost burden. As a non-volatile expansion memory such as the flash memory, a memory whose expandability of the memory capacity is large and which can achieve a memory capacity and cost burden in accordance with the requirements of users is desirable.

Further, it is desired to strengthen the security function of the memory area, strengthen a tamper resistant function, and enable the porting to the IC card having a different shape.

Hence, an object of the present invention is to provide a technique for an IC card, in which the expandability of the memory capacity is large, a memory capacity and cost burden in accordance with the requirements of users can be achieved, the security of the memory can be ensured, and the expansion of the porting to the different IC card and host equipment is possible.

The above and other objects and novel characteristics of the present invention will be apparent from the description of this specification and the accompanying drawings.

### Means for Solving the Problems

The typical ones of the inventions disclosed in this application will be briefly described as follows.

That is, an IC card according to the present invention is an IC card mounted with a flash memory, wherein the IC card can be inserted into a Plug-in SIM (Subscriber Identity Module) adaptor and/or a mini UICC (Universal Integrated Circuit Card) adaptor mounted with a secure IC, the IC card is inserted into the SIM adaptor or the mini UICC adaptor, so that the SIM adaptor or the mini UICC adaptor and the IC card are integrated to operate as a SIM attached with an expansion memory or a mini UICC attached with an expansion memory, and the IC card can be physically removed from the SIM adaptor or the mini UICC adaptor.

Also, when the IC card is not inserted, it may be operated as an ordinary SIM card (GSM card) and the like of the Plug-in SIM or mini UICC having no memory expansion. In this case, in order to ensure the physical strength of a conversion adaptor, a blank card which is a plastic card of the same shape as the IC card is inserted. The blank card is identical to the IC card in shape, but it is a card having no memory capacity.

Further, the IC card according to the present invention is an IC card mounted with a secure IC and operated as the SIM, wherein a flash memory card mounted with a flash memory can be inserted into the IC card, the flash memory card and the IC card are integrated to operate as the SIM attached with the expansion memory by inserting the flash memory card into the IC card, and the flash memory card can be physically removed from the IC card.

Further, the IC card according to the present invention is an IC card mounted with a secure IC and operated as the mini UICC, wherein a flash memory card mounted with a flash memory can be inserted into the IC card, the flash memory card and the IC card are integrated to operate as the mini UICC attached with the expansion memory by inserting the flash memory card into the IC card, and the flash memory card can be physically removed from the IC card.

The IC card according to the present invention realizes the Plug-in SIM or mini UICC function by directly connecting the signals of the smart card terminals and the signals provided in the flash memory card by wiring or connecting them by interposing an interface semiconductor between the signals. In the case of directly connecting the signals by the wiring, it is necessary to mount the secure function in the flash memory card.

Further, the interface semiconductor is mounted with a secure microcomputer function, and the interface semiconductor uses the protocol conversion of a secure command, so that the secure function can be omitted.

Further, the IC card according to the present invention is used not only for the smart card for the ISO7816, but also for others such as a memory stick PRO, a SD card, a multimedia card, and a USB memory by the simple conversion of a physical shape or by using a conversion adaptor through a controller for interface conversion.

Further, the flash memory card according to the present invention can be mounted with a device authentication function in order to determine whether or not the use of the IC card is properly authenticated. When not authenticated, the IC card is unable to use the flash memory card as an expansion memory.

Further, depending on the security level of the device authentication, a case of handling only the low security data or the non-security data may be discriminated from a case of handling the high security data.

Further, when the flash memory card according to the present invention is provided with the security function, an exchange of encrypted data, a decryption of encrypted data, an exchange of important secret key and the like can also be performed.

Further, the IC card according to the present invention is an IC card which is mounted with a secure IC chip having a security microcomputer function and is operated as the SIM, and it includes a first part having a first thickness and a second part thicker than the first thickness provided on an inner side of the first part.

Further, an IC card socket according to the present invention is an IC card socket into which a first IC card including a first part having a first thickness and a second part thicker than the first thickness provided on an inner side of the first part and a second IC card including a third part having the first thickness and a fourth part having the first thickness provided on an inner side of the third part can be inserted in common, and the IC card socket has a card retainer having a height capable of fixing the first IC card and the second IC card by retaining the first part and the third part and having a width not in contact with the second part.

### Effect of the Invention

The effects obtained by typical one of the inventions disclosed in this application will be briefly described below.

In the IC card, large expandability of the memory capacity, memory capacity and cost burden in accordance with the requirements of users can be achieved.

### BRIEF DESCRIPTION OF THE DRAWINGS

FIG. 1A is a block diagram showing the configuration of a SIM card examined as a premise of the present invention, and FIG. 1B is a view showing terminal allocation;
FIG. 2A is a structural drawing viewed from a SIC chip mounting side (opposite side of FIG. 1B) of the SIM card examined as a premise of the present invention. FIG. 2B is a cross sectional view along the line B-B' of FIG. 2A, and FIG. 2C is a cross sectional view along the line A-A' of FIG. 2A;
FIG. 3A is a block diagram showing a configuration of an IC card examined as a premise of the present invention, and FIG. 3B is a block diagram showing the configuration of the IC card according to one embodiment of the present invention;
FIG. 4 is an explanatory drawing showing a utilization model of the IC card according to one embodiment of the present invention;

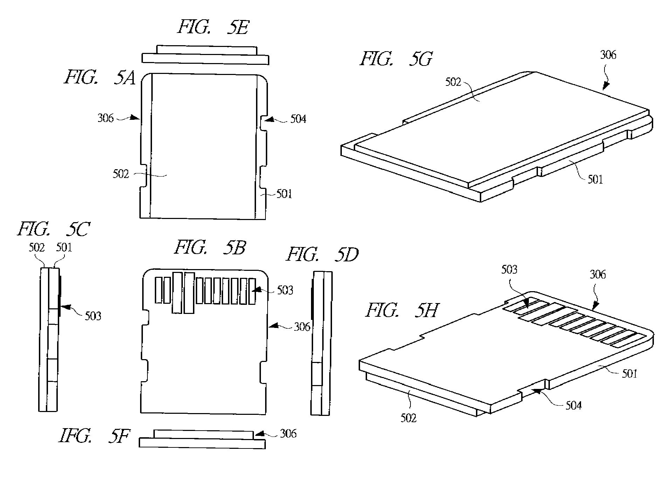

FIG. 5 is a full view showing the structure of a flash memory card according to one embodiment of the present invention. FIG. 5A is a plan view of the front surface of a flash memory card 306, FIG. 5B is a plan view of the rear surface of the flash memory card 306, FIG. 5C is a left side view of the flash memory card 306, FIG. 5D is a right side view of the flash memory card 306, FIG. 5E is a front view of the flash memory card 306, and FIG. 5F is a back view of the flash memory card 306. Further, FIG. 5G is a perspective view showing an external appearance on the front surface side of the flash memory card 306, and FIG. 5H is a perspective view showing an external appearance on the rear surface side of the flash memory card 306;
FIG. 6 is a full view showing the structure of a Plug-in SIM adaptor according to one embodiment of the present invention. FIG. 6A is a plan view of the rear surface side of a Plug-in SIM adaptor 305a, FIG. 6B is a plan view of the front surface side of the Plug-in SIM adaptor 305a, FIG. 6C is a side view of the Plug-in SIM adaptor 305a, and FIG. 6D is a cross sectional view along the line C-C' of FIG. 6B;
FIG. 7 is a plan view showing an outer shape after inserting the flash memory card into the Plug-in SIM adaptor according to one embodiment of the present invention;
FIG. 8A and FIG. 8B are longitudinal sectional views showing the structure of the Plug-in SIM adaptor according to one embodiment of the present invention;
FIG. 9 is a view showing an example of the connection in the Plug-in SIM adaptor according to one embodiment of the present invention;

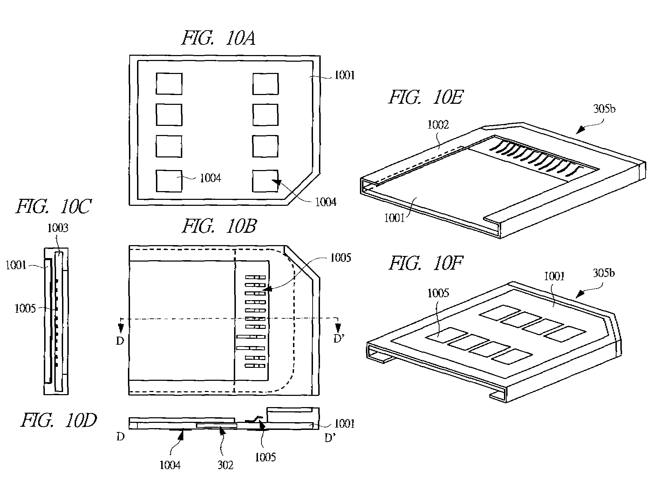

FIG. 10 is a full view showing the structure of a mini UICC adaptor according to one embodiment of the present invention. FIG. 10A is a plan view of the rear surface side of a mini UICC adaptor 305b, FIG. 10B is a plan view of the front surface side of the mini UICC adaptor 305b, FIG. 10C is a side view of the mini UICC adaptor 305b, and FIG. 10D is a cross sectional view along the line D-D' of FIG. 10B. Further, FIG. 10E is a perspective view showing the external appearance on the rear surface side of the mini UICC adaptor 305b, and FIG. 10F is a perspective view showing the external appearance on the front surface side of the mini UICC adaptor 305b;
FIG. 11 is a plan view showing an outer shape after inserting the flash memory card into the mini UICC adaptor according to one embodiment of the present invention;
FIG. 12 is a full view showing the structure of a memory stick micro adaptor according to one embodiment of the present invention. FIG. 12A is a plan view of the front surface of a memory stick micro adaptor 305c, FIG. 12B is a plan view of the rear surface of the memory stick micro adaptor 305c, and FIG. 12C is a side view of the memory stick micro adaptor 305c;
FIG. 13A and FIG. 13B are full views showing a method for loading the flash memory card on the memory stick micro adaptor according to one embodiment of the present invention;
FIG. 14A and FIG. 14B are full views showing a method for loading another flash memory card on the memory stick micro adaptor according to another embodiment of the present invention;

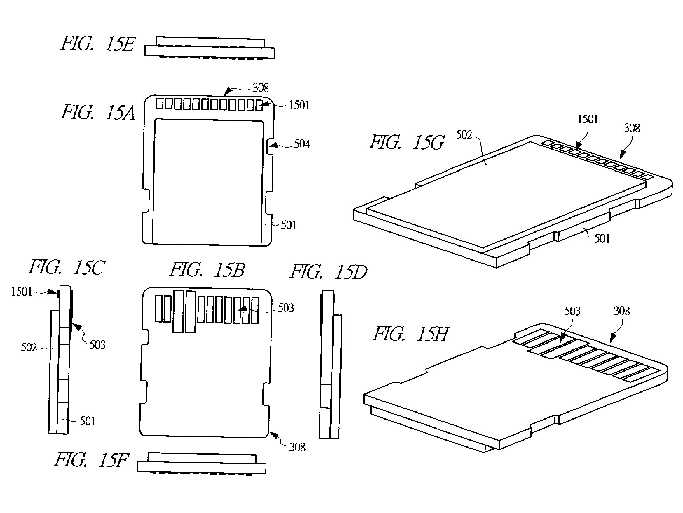

FIG. 15 is a full view showing another structural example of the flash memory card according to another embodiment of the present invention. FIG. 15A is a plan view of the front surface of a flash memory card 308, FIG. 15B is a plan view of the rear surface of the flash memory card 308, FIG. 15C is a left side view of the flash memory card 308, FIG. 15D is a right side view of the flash memory card 308, FIG. 15E is a front side of the flash memory card 308, and FIG. 15F is a back view of the flash memory card 308. Further, FIG. 15G is a perspective view showing the external appearance on the front surface side of the flash memory card 308, and FIG. 15H is a perspective view showing the external appearance on the rear surface side of the flash memory card 308;

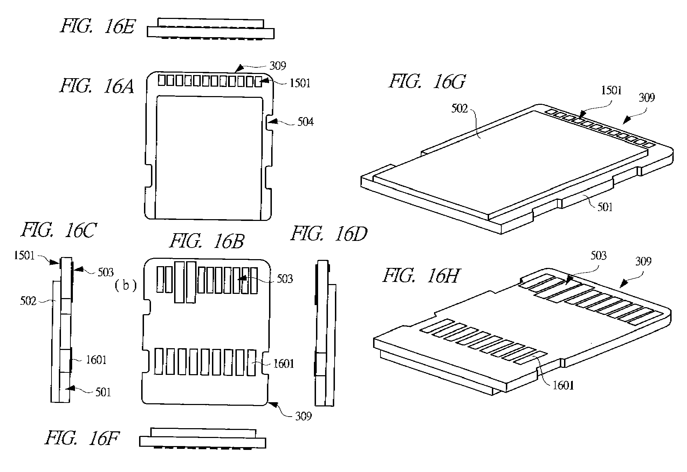

FIG. 16 is a full view showing another structural example of the flash memory card according to another embodiment of the present invention. FIG. 16A is a plan view of the front surface of a flash memory card 309, FIG. 16B is a plan view of the rear surface of the flash memory card 309, FIG. 16C is a left side view of the flash memory card 309, FIG. 16D is a right side view of the flash memory card 309, FIG. 16E is a front view of the flash memory card 309, and FIG. 16F is a back view of the flash memory card 309. Further, FIG. 16G is a perspective view showing the external appearance on the front surface side of the flash memory card 309, and FIG. 16H is a perspective view showing the external appearance on the rear surface side of the flash memory card 309;
FIG. 17 is a full view showing another structural example of the Plug-in SIM adaptor according to another embodiment of the present invention. FIG. 17A is a plan view of the rear surface side of a Plug-in SIM adaptor 305d, FIG. 17B is a plan view of the front surface side of the Plug-in SIM adaptor 305d, FIG. 17C is a side view of the Plug-in SIM adaptor 305d, and FIG. 17D is a cross sectional view along the line E-E' of FIG. 17B;

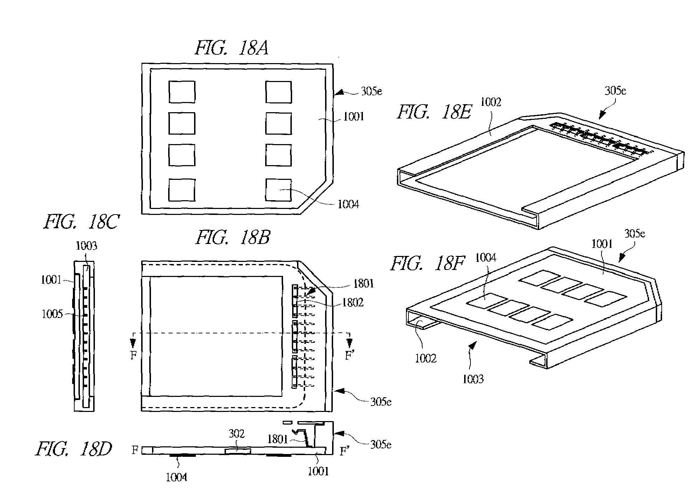

FIG. 18 is a full view showing another structural example of the mini UICC adaptor according to another embodiment of the present invention. FIG. 18A is a plan view of the rear surface side of a mini UICC adaptor 305e, FIG. 18B is a plan view of the front surface side of the mini UICC adaptor 305e, FIG. 18C is a side view of the mini UICC adaptor 305e, and FIG. 18D is a cross sectional view along the line F-F' of FIG. 18B. Further, FIG. 18E is a perspective view showing the external appearance on the rear surface side of the mini UICC adaptor 305e, and FIG. 18F is a perspective view showing the external appearance on the front surface side of the mini UICC adaptor 305e;

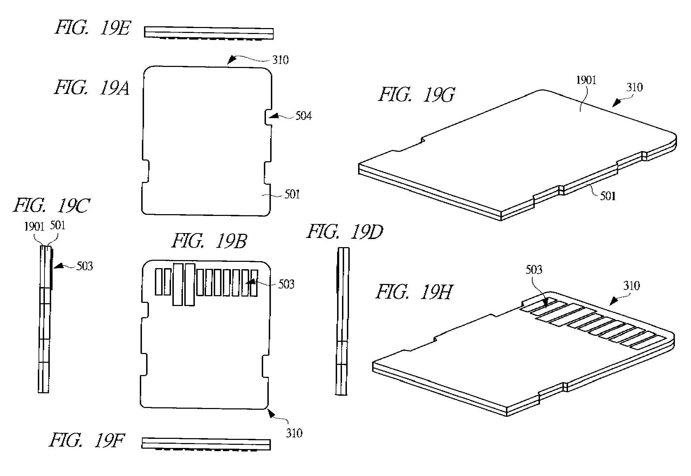

FIG. 19 is a full view showing another structural example of the flash memory card according to another embodiment of the present invention. FIG. 19A is a plan view of the front surface of a flash memory card 310, FIG. 19B is a plan view of the rear surface of the flash memory card 310, FIG. 19C is a left side view of the flash memory card 310, FIG. 19D is a right side view of the flash memory card 310, FIG. 19E is a front view of the flash memory card 310, and FIG. 19F is a back view of the flash memory card 310. Further, FIG. 19G is a perspective view showing the external appearance on the front surface side of the flash memory card 310, and FIG. 19H is a perspective view showing the external appearance on the rear surface side of the flash memory card 310;

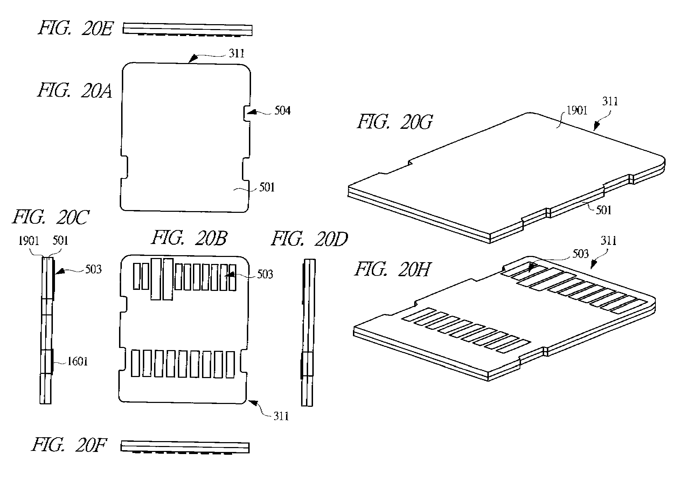

FIG. 20 is a full view showing another structural example of the flash memory card according to another embodiment of the present invention. FIG. 20A is a plan view of the front surface of a flash memory card 311, FIG. 20B is a plan view of the rear surface of the flash memory card 311, FIG. 20C is a left side view of the flash memory card 311, FIG. 20D is a right side view of the flash memory card 311, FIG. 20E is a front view of the flash memory card 311, and FIG. 20F is a back view of the flash memory card 311. Further, FIG. 20G is a perspective view showing the external appearance on the front surface side of the flash memory card 311, and FIG. 20H is a perspective view showing the external appearance on the rear surface side of the flash memory card 311;

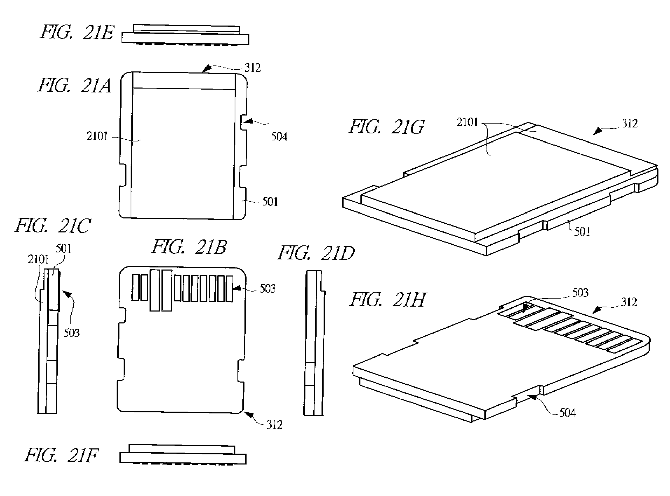

FIG. 21 is a full view showing another structural example of the flash memory card according to another embodiment of the present invention. FIG. 21A is a plan view of the front surface of a flash memory card 312, FIG. 21B is a plan view of the rear surface of the flash memory card 312, FIG. 21C is a left side view of the flash memory card 312, FIG. 21D is a right side view of the flash memory card 312, FIG. 21E is a front view of the flash memory card 312, and FIG. 21F is a back view of the flash memory card 312. Further, FIG. 21G is a perspective view showing the external appearance on the front surface side of the flash memory card 312, and FIG. 21H is a perspective view showing the external appearance on the rear surface side of the flash memory card 312;

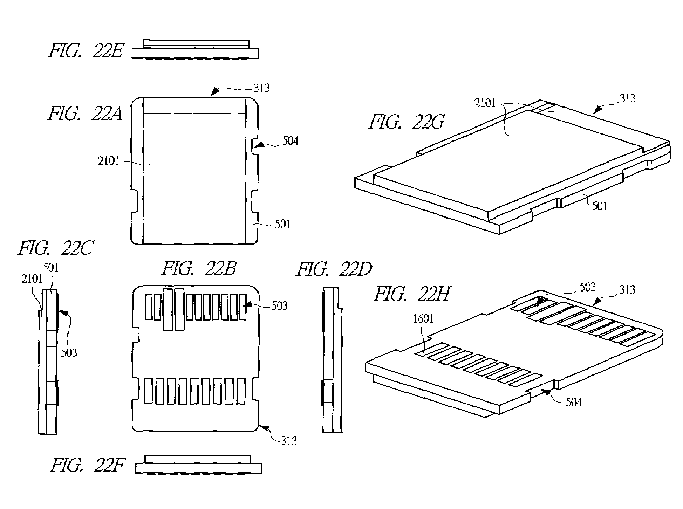

FIG. 22 is a full view showing another structural example of the flash memory card according to another embodiment of the present invention. FIG. 22A is a plan view of the front surface of a flash memory card 313, FIG. 22B is a plan view of the rear surface of the flash memory card 313, FIG. 22C is a left side view of the flash memory card 313, FIG. 22D is a right side view of the flash memory card 313, FIG. 22E is a front view of the flash memory card 313, and FIG. 22F is a back view of the flash memory card 313. Further, FIG. 22G is a perspective view showing the external appearance on the front surface side of the flash memory card 313, and FIG. 22H is a perspective view showing the external appearance on the rear surface side of the flash memory card 313;

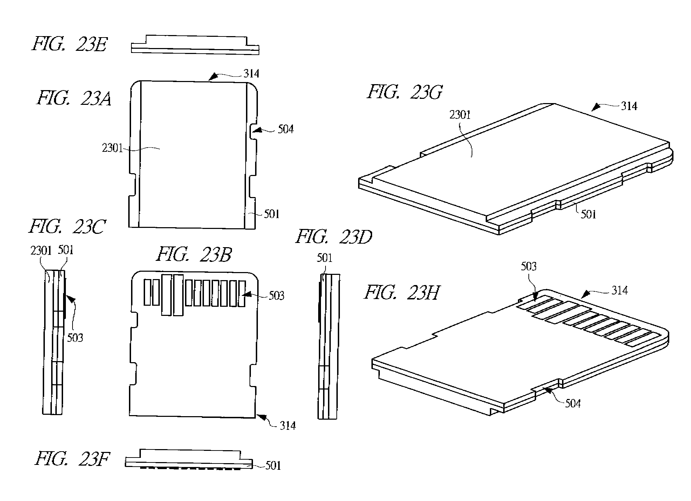

FIG. 23 is a full view showing another structural example of the flash memory card according to another embodiment of the present invention. FIG. 23A is a plan view of the front surface of a flash memory card 314, FIG. 23B is a plan view of the rear surface of the flash memory card 314, FIG. 23C is a left side view of the flash memory card 314, FIG. 23D is a right side view of the flash memory card 314, FIG. 23E is a front view of the flash memory card 314, and FIG. 23F is a back view of the flash memory card 314. Further, FIG. 23G is a perspective view showing the external appearance on the front surface side of the flash memory card 314, and FIG. 23H is a perspective view showing the external appearance on the rear surface side of the flash memory card 314;

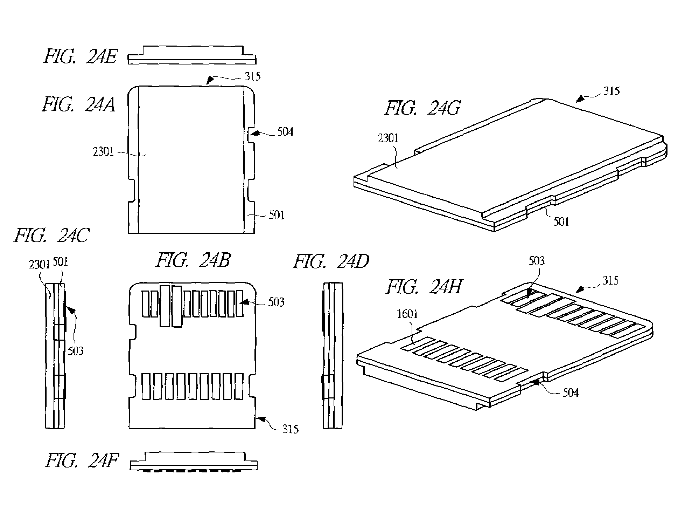

FIG. 24 is a full view showing another structural example of the flash memory card according to another embodiment of the present invention. FIG. 24A is a plan view of the front surface of a flash memory card 315, FIG. 24B is a plan view of the rear surface of the flash memory card 315, FIG. 24C is a left side view of the flash memory card 315, FIG. 24D is a right side view of the flash memory card 315, FIG. 24E is a front view of the flash memory card 315, and FIG. 24F is a back view of the flash memory card 315. Further, FIG. 24G is a perspective view showing the external appearance on the front surface side of the flash memory card 315, and FIG. 24H is a perspective view showing the external appearance on the rear surface side of the flash memory card 315;

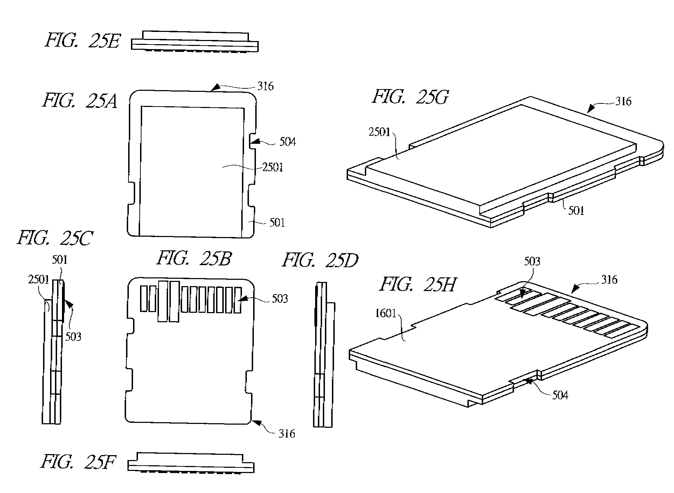

FIG. 25 is a full view showing another structural example of the flash memory card according to another embodiment of the present invention. FIG. 25A is a plan view of the front surface of a flash memory card 316, FIG. 25B is a plan view of the rear surface of the flash memory card 316, FIG. 25C is a left side view of the flash memory card 316, FIG. 25D is a right side view of the flash memory card 316, FIG. 25E is a front view of the flash memory card 316, and FIG. 25F is a back view of the flash memory card 316. Further, FIG. 25G is a perspective view showing the external appearance on the front surface side of the flash memory card 316, and FIG. 25H is a perspective view showing the external appearance on the rear surface side of the flash memory card 316;

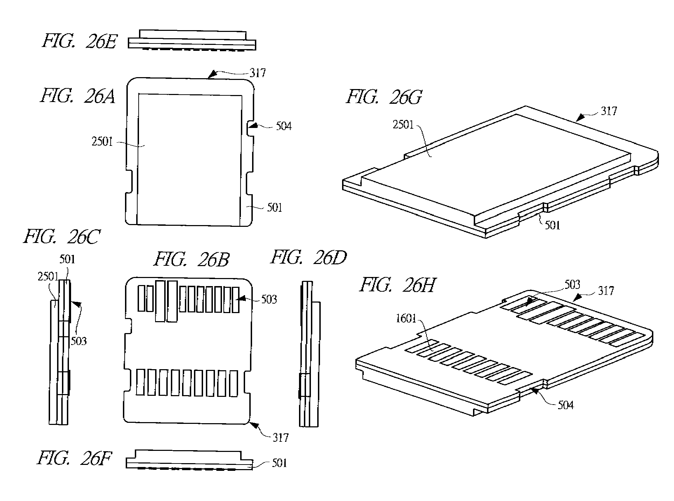

FIG. 26 is a full view showing another structural example of the flash memory card according to another embodiment of the present invention. FIG. 26A is a plan view of the front surface of a flash memory card 317, FIG. 26B is a plan view of the rear surface of the flash memory card 317, FIG. 26C is a left side view of the flash memory card 317, FIG. 26D is a right side view of the flash memory card 317, FIG. 26E is a front view of the flash memory card 317, and FIG. 26F is a back view of the flash memory card 317. Further, FIG. 26G is a perspective view showing the external appearance on the front surface side of the flash memory card 317, and FIG. 26H is a perspective view showing the external appearance on the rear surface side of the flash memory card 317;

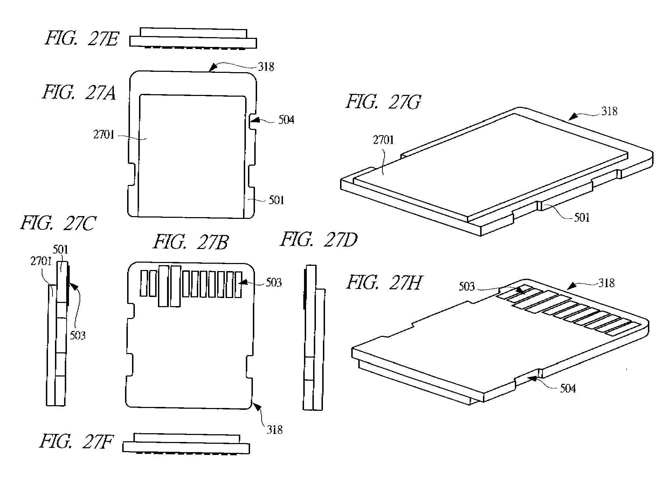

FIG. 27 is a full view showing another structural example of the flash memory card according to another embodiment of the present invention. FIG. 27A is a plan view of the front surface of a flash memory card 318, FIG. 27B is a plan view of the rear surface of the flash memory card 318, FIG. 27C is a left side view of the flash memory card 318, FIG. 27D is a right side view of the flash memory card 318, FIG. 27E is a front view of the flash memory card 318, and FIG. 27F is a back view of the flash memory card 318. Further, FIG. 27G is a perspective view showing the external appearance on the front surface side of the flash memory card 318, and FIG. 27H is a perspective view showing the external appearance on the rear surface side of the flash memory card 318;

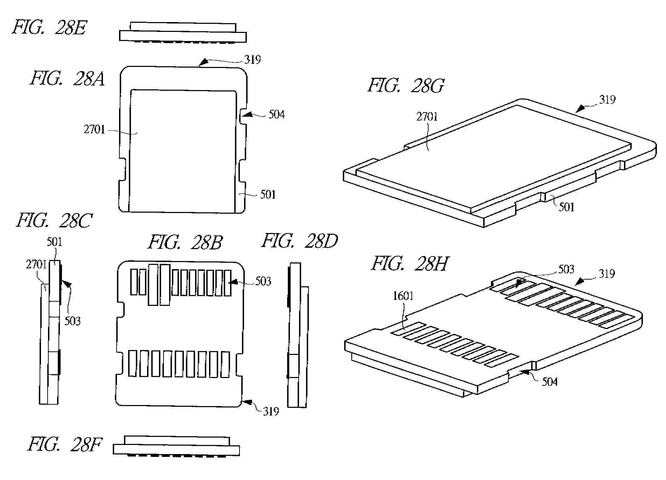

FIG. 28 is a full view showing another structural example of the flash memory card according to another embodiment of the present invention. FIG. 28A is a plan view of the front surface of a flash memory card 319, FIG. 28B is a plan view of the rear surface of the flash memory card 319, FIG. 28C is a left side view of the flash memory card 319, FIG. 28D is a right side view of the flash memory card 319, FIG. 28E is a front view of the flash memory card 319, and FIG. 28F is a back view of the flash memory card 319. Further, FIG. 28G is a perspective view showing the external appearance on the front surface side of the flash memory card 319, and FIG. 28H is a perspective view showing the external appearance on the rear surface side of the flash memory card 319;
FIG. 29 is a full view showing the structure of a smart card conversion adaptor according to another embodiment of the present invention. FIG. 29A is a plan view of the front surface of a smart card (ID-1) conversion adaptor 305f, FIG. 29B is a side view of the smart card (ID-1) conversion adaptor 305f, and FIG. 29C is a cross sectional view along the line G-G' of FIG. 29A;
FIG. 30 is a block diagram showing a system configuration example of an IC card according to another embodiment of the present invention;
FIG. 31 is a view showing a memory map of the flash memory card according to another embodiment of the present invention;
FIG. 32 is a schematic diagram showing the functions of the connecter terminals of the flash memory card according to one embodiment of the present invention;
FIG. 33 is a schematic diagram showing the functions of the connecter terminals of the flash memory card according to another embodiment of the present invention;
FIG. 34 is a schematic diagram showing the functions of the connecter terminals of the flash memory card according to another embodiment of the present invention;
FIG. 35 is a full view showing the structure of a conventional Plug-in SIM card, and FIG. 35A is a bottom view, FIG. 35B is a plan view, FIG. 35C is a right side view, and FIG. 35D is a front view;
FIG. 36 is a full view showing a schematic structure of the Plug-in SIM card according to a seventeenth embodiment of the present invention, and FIG. 36A is a bottom view, FIG. 36B is a plan view, FIG. 36C is a right side view, and FIG. 36D is a front view;
FIG. 37 is a cross sectional view showing the schematic structure of the Plug-in SIM card according to the seventeenth embodiment of the present invention;
FIG. 38 is a cross sectional view showing the schematic structure of the Plug-in SIM card according to the seventeenth embodiment of the present invention;
FIG. 39 is a full view showing the schematic structure of a partly thick Plug-in SIM adaptor according to an eighteenth embodiment of the present invention, and FIG. 39A is a back view, FIG. 39B is a left side view, FIG. 39C is a plan view, FIG. 39D is a right side view, FIG. 39E is a bottom view, and FIG. 39F is a front view;
FIG. 40 is a cross sectional view showing the schematic structure of the partly thick Plug-in SIM adaptor (before a memory card is inserted) according to an eighteenth embodiment of the present invention;
FIG. 41 is a cross sectional view showing the schematic structure of the partly thick Plug-in SIM adaptor (after a memory card is inserted) according to the eighteenth embodiment of the present invention;
FIG. 42 is a full view showing the structure of the partly thick Plug-in SIM adaptor (for micro SD) according to a nineteenth embodiment of the present invention, and FIG. 42A is a bottom view, FIG. 42B is a plan view, FIG. 42C is a right side view, and FIG. 42D is a front view;
FIG. 43 is a full view showing the structure of the partly thick Plug-in SIM adaptor (for micro SD) except for an upper retainer lid according to the nineteenth embodiment of the present invention, and FIG. 43A is a plan view, FIG. 43B is a right side view, and FIG. 43C is a front view;
FIG. 44 is a perspective view showing a state (before insertion) in which the micro SD card is inserted into the partly thick Plug-in SIM adaptor (for micro SD) according to the nineteenth embodiment of the present invention;
FIG. 45 is a perspective view showing a state (in the middle of the insertion) in which the micro SD card is inserted into the partly thick Plug-in SIM adaptor (for micro SD) according to the nineteenth embodiment of the present invention;
FIG. 46 is a perspective view showing a state (after the insertion) in which the micro SD card is inserted into the partly thick Plug-in SIM adaptor (for micro SD) according to the nineteenth embodiment of the present invention;
FIG. 47 is a view showing the outer shape of an ordinary M2 memory card, and FIG. 47A is a left side view, FIG. 47B is a plan view, FIG. 47C is a right side view, and FIG. 47D is a front view;
FIG. 48 is a view showing the outer shape of a M2 memory card according to a twentieth embodiment of the present invention, and FIG. 48A is a left side view, FIG. 48B is a plan view, FIG. 48C is a right side view, and FIG. 48D is a front view;
FIG. 49 is a full view showing the structure of the partly thick Plug-in SIM adaptor (for M2) according to a twenty-first embodiment of the present invention, and FIG. 49A is a plan view, FIG. 49B is a right side view, and FIG. 49C is a front view;
FIG. 50 is a full view showing a state after the ordinary M2 memory card is inserted into the partly thick Plug-in SIM adaptor according to the twenty-first embodiment of the present invention, and FIG. 50A is a plan view, FIG. 50B is a right side view, and FIG. 50C is a front view;
FIG. 51 is a full view showing a state after the M2 memory card according to the twentieth embodiment is inserted into the partly thick Plug-in SIM adaptor according to the twenty-first embodiment of the present invention, and FIG. 51A is a plan view, FIG. 51B is a right side view, FIG. 51C is a front view, and FIG. 51D is a right side view showing the state after the ordinary M2 memory card is inserted for comparison;
FIG. 52 is a full view of an IC card socket according to a twenty-second embodiment of the present invention, and FIG. 52A is a plan view, FIG. 52B is a right side view, and FIG. 52C is a front view;
FIG. 53 is a full view showing a state after the partly thick Plug-in SIM adaptor (or card) is inserted into the IC card socket according to the twenty-second embodiment of the present invention, and FIG. 53A is a plan view, FIG. 53B is a right side view, and FIG. 53C is a front view; and
FIG. 54 is a full view showing a state after the Plug-in SIM adaptor (or card) with a thickness of 0.76 mm is inserted into the IC card socket according to the twenty-second embodiment of the present invention, and FIG. 54A is a plan view, FIG. 54B is a right side view, and FIG. 54C is a front view.

### BEST MODE FOR CARRYING OUT THE INVENTION

Hereinafter, embodiments of the present invention will be described in detail with reference to the accompanying drawings. Note that components having the same function are denoted by the same reference numbers throughout the drawings for describing the embodiments, and the repetitive description thereof will be omitted.

For the easy understanding of the features of the present invention, the present invention will be described while comparing with the premise technique of the present invention.

### (First Embodiment)

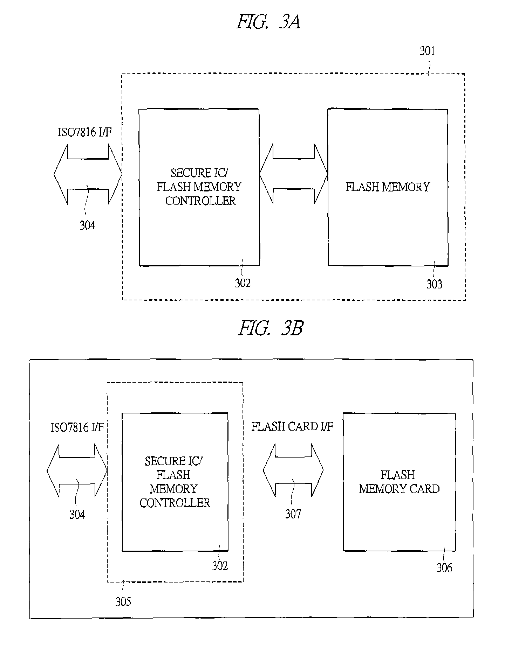

FIG. 3A is a block diagram showing a configuration of an IC card examined as a premise of the present invention.

An IC card shown in FIG. 3A is the conventional integrated SIM memory 301 described in the Patent Document 1. This SIM memory 301 is constituted of an IC chip mounted with a secure IC/flash memory controller 302 and an IC chip of a flash memory 303. Further, the SIM memory 301 has an ISO7816 I/F (interface) through the ISO7816 interface terminals C1 to C8 conforming to the standards of ISO/IEC7816-3, and is connected to external equipment.

FIG. 3B is a block diagram showing the configuration of the IC card according to one embodiment of the present invention.

The IC card shown in FIG. 3B is a SIM memory adaptor 305 including the IC chip of the secure IC/flash memory controller 302. Similar to the conventional integrated SIM memory 301, the SIM memory adaptor 305 includes the ISO7816 I/F 304 through the ISO7816 interface terminals C1 to C8 conforming to the standards of the ISO/IEC7816-3, and can be connected to the external equipment. Further, the SIM memory adaptor 305 can be connected to a flash memory card 306 having the flash memory through a flash card I/F 307 via a connector terminal electrically connecting the signal with a slot retaining the card. More specifically, the flash memory is included in the flash memory card 306, and this flash memory card 306 can be physically removed from the SIM card and is connectable and removable by the SIM memory adaptor 305. The ISO7816 I/F 304 and the flash card I/F 307 can also conform to a smart card I/F.

Further, though described in detail later, the flash card I/F can also be used as the existing memory card I/F. As the existing memory card I/F, for example, a serial interface such as a memory stick PRO, a SD card, a multimedia card, a USB, a TCP/IP, an I²C, a serial interface communication (SCI), and the like can be enumerated.

The features of the IC card according to the present embodiment shown in FIG. 3B are as follows.
(1) The flash memory card 306 and the SIM memory adaptor 305 can be physically removed. More specifically, they can be repeatedly removed or connected through a connector mechanism. In other words, the flash memory card 306 and the SIM memory adaptor 305 are removable.
(2) The flash card I/F 307 is not always necessary to be the same as the ISO7816 I/F 304. For example, it is possible to use the memory card I/F or the serial I/F described above.
(3) The flash memory card 306 can be contained in the SIM memory adaptor 305 (Plug-in SIM size).
(4) The flash memory card 306 can be contained in the mini UICC adaptor (mini UICC size).
(5) The IC card can be used as an existing memory card by mounting it on a conversion adaptor of the existing memory card. As the existing memory card, the memory stick micro, the memory stick Duo, and the memory stick can be enumerated.
(6) By mounting an interface conversion circuit on a conversion adaptor of the existing memory card, it can be used as existing memory cards such as a SD (Secure Digital) card (standards regulated by the SD card Association are available), a mini SD, a MMC (Multi Media Card, which is a registered trademark of Infineon Technologies AG), RS-MMC, USB, and the like.
(7) The flash memory card 306 inserted into the SIM memory adaptor 305 is authenticated as a trusted device. This card operates only when the flash memory card 306 and the SIM memory adaptor 305 pass the mutual device authentication. When not authenticated, the use thereof is not admitted or denied and shut down as nonqualified.
(8) The flash memory card 306 inserted into the SIM memory adaptor 305 is mounted with the SIC (Secure IC) and may function as the Plug-in SIM and the mini UICC. Even when the flash memory card 306 is not inserted, the SIM memory adaptor 305 operates as the ordinary SIM. In this case, the SIM adaptor is mounted with a secure microcomputer. Further, when not inserted, a blank card which does not operate electrically is inserted. The blank card will be described in detail later.
(9) A semiconductor chip mounted in the SIM memory adaptor 305 is mounted in the area obtained by excluding the area of the flash memory card 306 from the outer shape of the SIM. The same holds true with the mini UICC adaptor.

The advantages of using the flash card I/F 307 are as follows.
(1) When the flash memory card 360 contains a controller chip for controlling the flash memory, memory management is easy. When a flash memory I/F of a NAND memory or others is directly used, management of the number of writing times, the defective area management, the pad management, and the like are required, and the memory reliability can be ensured.
(2) A memory capacity in accordance with the need of a user can be selected. Expandability of the memory capacity is large, and the memory capacity can be changed. Further, since it is removable, the transition to the mini UICC from the Plug-in SIM is facilitated.
(3) Disconnection from the standardization is possible. It is possible to incorporate the next generation functions of the ISO interface. More specifically, since the interface added with the next generation functions of ETSI and the flash memory are separated, it can be updated by inserting it into a new interface adaptor. Further, interface defect standardization is also easy.
(4) The flash memory card 306 may have both the I/F for the SIM and the I/F for the existing memory card. By using the device authentication, only the flash memory card that meets the purpose is used, and unknown failures and a collapse of the security due to other compatibility failures can be prevented. For the device authentication, the secure functions of the flash card and the like may be used.

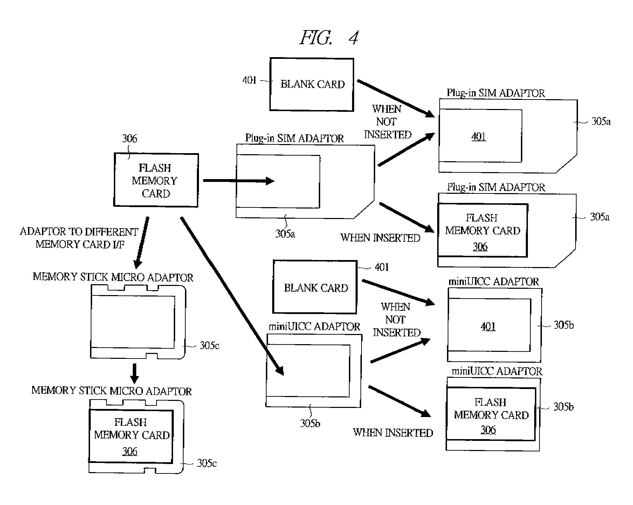

FIG. 4 is an explanatory drawing showing the utilization model of the IC card according to one embodiment of the present invention.

As shown in FIG. 4, the flash memory card 306 is an ultra thin type memory card thinner than the conventional smart card, and has a flash memory chip and a control chip for controlling the flash memory chip.

Further, the flash memory card 306 can be inserted into the Plug-in SIM adaptor 305a. When the flash memory card 306 is inserted into the Plug-in SIM adaptor 305a, it is operated as the Plug-in SIM with the expansion memory. The Plug-in SIM with the expansion memory can function as a highly functional subscriber identification module having a function as a so-called IC card capable of executing the security processing and a function as a so-called memory card having a larger capacity and a higher performance than the IC card. More specifically, the Plug-in SIM with the expansion memory can be used as, for example, a card for the mobile phone in which the information including telephone numbers and a telephone directory is stored. Further, the Plug-in SIM with the expansion memory can be used in a variety of fields requiring a high security such as the finance, the traffic, the communication, the distribution, and the authentication, that is, in the form of a credit card, a cash card, a card for ETC (Electronic Toll Collection System) system, a commuter pass, an authentication card, and the like. In addition, the Plug-in SIM with the expansion memory is configured to be usable as recording media of mobile information equipment requiring portability such as a digital camera, a note-book size personal computer, a portable music player, a mobile phone, and the like.

Similar to the SIM card, the outer dimensions of the Plug-in SIM adaptor 305a conform to, for example, the standards of the Plug-in UICC (Universal Integrated Circuit Card) of ETSI TS 102 221 V4.4.0 (2001-10), and are 15 mm x 25 mm x 0.76 mm. More specifically, the planar dimensions are 15 mm x 25 mm, and the thickness is approximately 0.76 mm. The thickness is allowed in the range of 0.76 mm±0.08 mm, and can be 0.84 mm or less. The outer dimensions of the flash memory card 306 are smaller than the Plug-in, SIM adaptor 305a, and the thickness thereof is thinner than 0.76 mm of the Plug-in SIM adaptor 305a.

When the flash memory card 306 is not inserted into the Plug-in SIM adaptor 305a, the Plug-in SIM adaptor 305a can be operated as the conventional Plug-in SIM by inserting a blank card 401. The blank card 401 is made of, for example, plastic that contains materials such as polyvinyl chloride (PVC), polycarbonate, polyolefin (polypropylene and the like), polyethylene terephthalate (PET), polyethylene terephthalate glycol (PET-G), acrylonitrile butadiene styrene resin (ABS) and the like. Further, unlike the flash memory card 306, the blank card 401 does not contain an IC chip such as the flash memory chip and the controller chip. The outer dimensions of the blank card 401 are formed similarly to those of the flash memory card 306. When the Plug-in SIM adaptor 305a according to the present embodiment is used as the conventional SIM card having no memory expansion function, the blank card 401 is inserted, so that the strength of the Plug-in SIM adaptor 305a can be secured as compared with the case where nothing is inserted. At this time, this blank card 401 is not essential, and even when the blank card 401 is not used, it is possible to use the Plug-in SIM adaptor 305a according to the present embodiment as the conventional SIM card having no memory expansion function. However, it is more preferable to use the blank card 401 when the securement of the strength as described above is taken into consideration.

Further, it is also possible to incorporate a controller chip in the blank card 401 to give an operation permission to the Plug-in SIM adaptor 305a.

Further, the flash memory card 306 can be inserted also into the mini UICC adaptor 305b. When the flash memory card 306 is inserted into the mini UICC adaptor 305b, it is operated as the mini UICC attached with the expansion memory. Here, the mini UICC adaptor 305b conforms to the outer shape standards of the mini UICC card, and its outer dimensions are approximately 15 mm × 12 mm × 0.76 mm. More specifically, the planar dimensions thereof are 15 mm × 12 mm, and the thickness thereof is approximately 0.76 mm.

Further, similar to the case where the flash memory card 306 is not inserted into the Plug-in SIM adaptor 305a, when the flash memory card 306 is not inserted into the mini UICC adaptor 305b, the mini UICC adaptor 305b can be operated as the conventional mini UICC by inserting the blank card 401. The configuration and the function of the blank card 401 are the same as the example of the Plug-in SIM adaptor 305a described above. Further, it is also possible to incorporate a controller chip in the blank card 401 to give the operation permission to the mini UICC adaptor 305b.

Further, the flash memory card 306 can be inserted also into an adaptor to an I/F of different types of memory cards, for example, a memory stick micro adaptor 305c. When the flash memory card 306 is inserted into the memory stick micro adaptor 305c, it is operated as a memory stick micro. An adaptor simply converting the physical dimensions can be used as the adaptor in this case. Here, the physical dimension conversion means that no controller for interface is provided. As the I/F of different types of memory cards, I/F of USB, smart card, SD card, MMC card, and the like are also available. When the protocol and the system of the interfaces are different, the adaptor mounted with a controller is necessary.

FIG. 5 is a full view showing the structure of the flash memory card 306 which is the ultra thin type memory card according to the present embodiment. FIG. 5A is a plan view of the front surface of the flash memory card 306, FIG. 5B is a plan view of the rear surface of the flash memory card 306, FIG. 5C is a left side view of the flash memory card 306, FIG. 5D is a right side view of the flash memory card 306, FIG. 5E is a front view of the flash memory card 306, and FIG. 5F is a back view of the flash memory card 306. Further, FIG. 5G is a perspective view showing an external appearance on the front surface side of the flash memory card 306, and FIG. 5H is a perspective view showing the external appearance on the rear surface side of the flash memory card 306.

The flash memory card 306 is an ultra thin type memory card, and a plurality of IC chips are mounted on the surface of a substrate 501 (wiring board 501). As the IC chips, for example, the flash memory chip and the controller chip for controlling the flash memory chip are mounted. These IC chips are connected to connecter pads on the substrate 501 by wire-bonding, respectively, and the connector pads are electrically connected to the connector terminals 503 (external connector terminals 503) arranged on the rear surface of the substrate 501 through the through holes formed in the substrate 501. These flash memory chip, controller chip, wire-bonding, and connecter pads are covered with sealing resin 502 (mold 502).

The sealing resin 502 is made of resin such as epoxy based resin and an ultraviolet (UV) curing resin and is formed by injection molding. The sealing resin 502 is formed on the surface of the substrate 501 and is provided so that notches 504 (notch grooves 504) on both side surfaces are exposed, whereby steps are formed between the substrate 501 and the sealing resin 502.

The notches 504 formed on both side surfaces are provided for the purpose of fixing the flash memory card 306 when the flash memory card 306 is inserted into the Plug-in SIM adaptor 305a, the mini UICC adaptor 305b or the adaptor to the I/F of the different types of memory cards. Further, also when the flash memory card 306 is used independently, they fix the flash memory card 306 inside the slot of the external device.

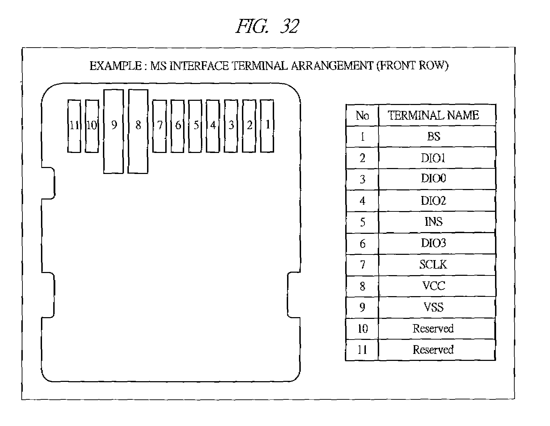

A plurality of connector terminals 503 are provided on the rear surface of the substrate 501 on the front side of the flash memory card 306. The functions of each terminal are shown in FIG. 32, that is, No. 1 is for BS, No. 2 is for DIO1 (input/output), No. 3 is for DIO0 (input/output), No. 4 is for DIO2 (input/output), No. 5 is for INS, No. 6 is for DIO3 (input/output), No. 7 is for SCLK (clock), No. 8 is for VCC (power supply), No. 9 is for VSS (ground), No. 10 and No. 11 are for Reserved. Here, the reserved terminals can be used as expansion terminals for the realization of a USB interface, the realization of MMC or serial interface and the like.

Further, though not particularly illustrated, a plurality of test terminals are formed on the back side of the connecter terminals 503 on the rear surface of the substrate 501. By these test terminals, direct access control of the flash memory chip can be made through the test terminals from outside when the controller chip is made incapable of performing the memory control operations due to electrostatic breakdown and others. Therefore, even when the control chip is broken down, if data is left in the flash memory chip, this can be easily recovered. Usually, these test terminals are covered with an insulating seal and a solder resist and are made unusable.

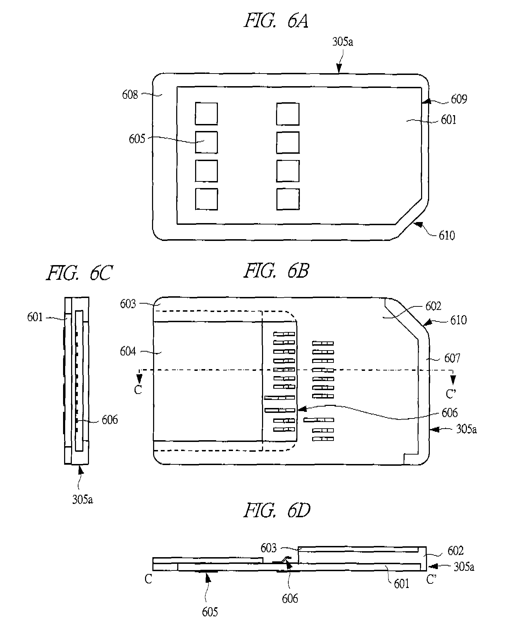

FIG. 6A to FIG. 6D are full views showing the structure of the Plug-in SIM adaptor 305a. FIG. 6A is a plan view of the rear surface side of the Plug-in SIM adaptor 305a, FIG. 6B is a plan view of the front surface side of the Plug-in SIM adaptor 305a, FIG. 6C is a side view of the Plug-in SIM adaptor 305a, and FIG. 6D is a cross sectional view along the line C-C' of FIG. 6B.

The Plug-in SIM adaptor 305a has a module area 602 mounted with the secure IC/flash memory controller 302 and the like on a substrate 601, and the module area 602 is covered with a metal plate 603. A space for inserting the flash memory card 306, that is, a slot 604 is provided between the substrate 601 and the metal plate 603. On the surface of the substrate 601, a plurality of ISO7816 electrodes 605 for the ISO7816 I/F 304 are arranged. In the slot 604, a plurality of connecter terminals 606 for the flash card I/F 307 are arranged on the substrate 601. The connecter terminals 606 may be multi-contact terminals having plural contacts per one terminal so as to guarantee contact certainty. Further, a chamfered part 610 is provided at one of four corners of the Plug-in SIM adaptor 305a, and the slot 604 is arranged on the opposite side of the chamfered part 610 and the secure IC/flash memory controller 302 and the like are arranged on the chamfered part 610 side.

Insulation treatment is applied to the top end part 607 of the metal plate 603. By the insulation treatment, the electrical short-circuit to the host equipment caused when the Plug-in SIM adaptor 305a is inserted into the host equipment can be prevented. The metal plate 603 may cover the entire module area 602. The substrate 601 is coupled to a metal frame guide 608 and mechanically retains it. In the case of the integral molding by the sealing resin, a step with the substrate boundary 609 is eliminated, and it is practically flattened. The four corners of the metal frame guide 608 and the metal plate 603 are rounded and chamfered in order to reduce insertion damages to the host equipment. The value of a curvature radius (R) at that time may be optional.

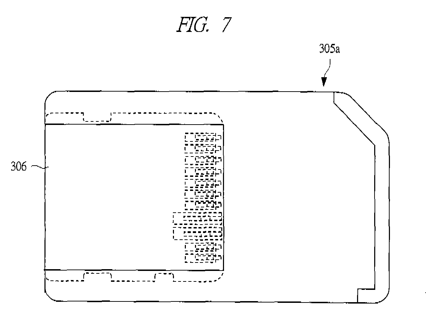

FIG. 7 is a plan view showing an outer shape after inserting the flash memory card 306 into the Plug-in SIM adaptor 305a.

The dotted line shows the position of the inserted flash memory card 306. Note that the connecter terminals 503 of the flash memory card 306 and the connector terminals 606 of the Plug-in SIM adaptor 305a are also shown by the dashed line. The Plug-in SIM adaptor 305a may be provided with a mechanical latch using the concavities of the notch 504 of the flash memory card 306 and a presence detect SW for preventing detachment or detecting the card. In the figure, the flash memory card 306 is retained by the substrate 501, and is inserted by being guided by the slot part of the Plug-in SIM adaptor 305a. At this time, the sealing resin 502 is exposed from the opening of the metal plate 603. The connecter terminals 503 of the flash memory card 306 are brought into contact with the connecter terminals 606 of the Plug-in SIM adaptor 305a, thereby ensuring the electric conductance.

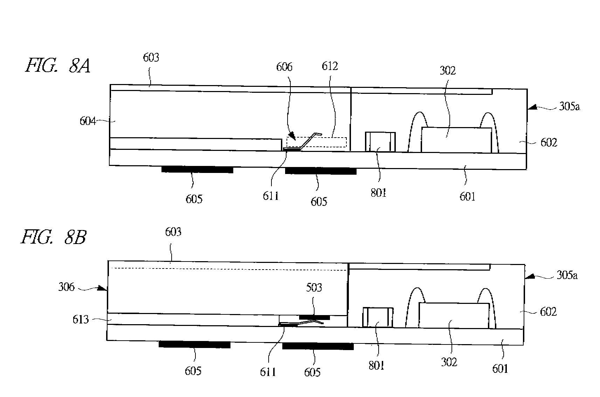

FIG. 8 is a cross sectional view showing the sectional view of the Plug-in SIM adaptor 305a along the line C-C' in FIG. 6B in detail. FIG. 8A is a view showing the state before the flash memory card 306 is inserted, and FIG. 8B is a view showing the state after the flash memory card 306 is inserted.

On the substrate 601 serving as a wiring layer and a wiring board, there are the module area 602 in which IC chips such as the secure IC/flash memory controller 302 and chip parts 801 such as a passive element and an active element are mounted and the connector terminals 606 bonded by soldering, welding, and the like. In the figure, the soldering is shown as solder 611. The connecter terminals 606 are provided between the module area 602 on the front side of the Plug-in SIM adaptor 305a and the step part 613 provided on the back side. This step part 613 is formed of the sealing resin and is formed simultaneously with the sealing resin 502. Further, this step part 613 may be provided by providing a step on the substrate 501 or can be formed by using an insulating material such as a tape.

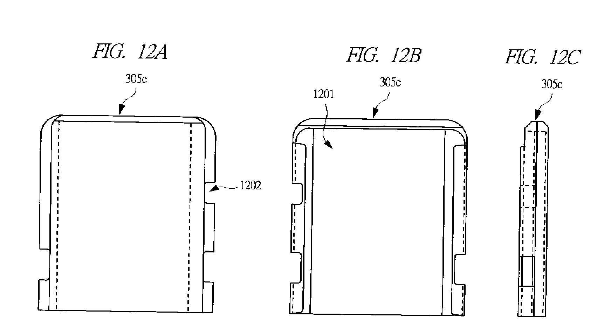

Between the tips of the connecter terminals 606 and the substrate 601, a terminal escape space 612 (opening 612) is provided. Because of the provision of such a space 612, even when the connecter terminals 606 of the Plug-in SIM adaptor 305a are pushed out by the connector terminals 503 of the flash memory card 306 when the flash memory card 306 is inserted as shown in FIG. 12B, that area can be ensured. More specifically, the distance between the step part 613 and the module area 602 is designed so as to be longer than the length of the connecter terminal.

On the surface of the substrate 601, a plurality of ISO7816 electrodes 605 are arranged. On the module area 602, the metal plate 603 and the like are provided. The surface of this metal plate 603 may be coated with the insulating resin like the top end part 607. In that case, an electrical short-circuit to the host equipment caused when the Plug-in SIM adaptor 305a is inserted into the host equipment can be prevented.

As shown in FIG. 8B, after the flash memory card 306 is inserted into the Plug-in SIM adaptor 305a, the connecter terminals 606 of the Plug-in SIM adaptor 305a are brought into contact with the connecter terminals 503 of the flash memory card 306, and the connecter terminals 606 are bent to the substrate 601 side, so that electrical contact certainty is ensured.

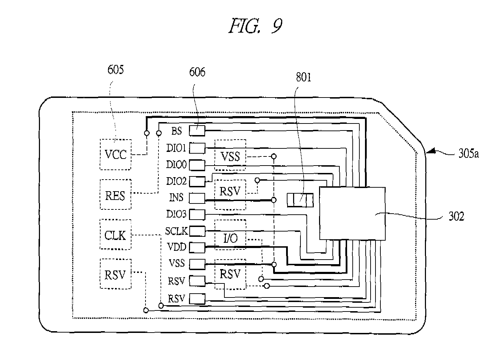

FIG. 9 is a view showing an example of the connection in the Plug-in SIM adaptor 305a.

IC chips such as the secure IC/flash memory controller 302 and chip parts 801 such as the passive elements and the active element including capacitor, resistor, and coil are mounted in the Plug-in SIM adaptor 305a. The IC chips such as the secure IC/flash memory controller 302 may be one chip or plural chips. Further, these IC chips 302 and chip parts 801 are sealed with the sealing resin, so that the shape and strength thereof are secured.

The secure IC/flash memory controller does not always have the secure microcomputer function and can be formed by a controller for protocol conversion only in some cases. Further, when the secure IC function is mounted in the memory card, it can be formed to have only the function for the wiring connection conversion with no controller. More specifically, this means that it becomes the terminal conversion adaptor.

In the Plug-in SIM adaptor 305a, the plurality of ISO7816 electrodes 605 for the ISO7816 I/F 304 and the plurality of connecter terminals 606 for the flash card I/F 307 are wire-connected to IC chips such as the secure IC/flash memory controller 302 and the chip parts 801. Note that the wirings of the chip parts 801 are omitted. Although an example of a two-layer wiring is shown in FIG. 9, three or more layer wiring may be adopted. Further, the wiring may be formed of a metal frame or a metal wiring lead frame by press. The metal wiring frame is formed by insert-mold and the like with the insulating resin.

In the ISO7816 electrodes 605, VCC is a VCC power supply terminal, RES is a reset terminal, CLK is a clock terminal, RSV is a reserve terminal, VSS is a ground terminal, and I/O is an input/output terminal. In the connecter terminals 606, BS is a bus state terminal, DIO0, DIO1, DIO2, and DIO3 are data input/output terminals, INS is an insert detection terminal, SCLK is a system clock terminal, VDD is a VDD power supply terminal, VSS is a ground terminal, and RSV is a reserve terminal, which basically have exchangeability with the memory stick PRO. Further, the reserved terminals can be used for the desired purposes as function expansion terminals such as ETSI.

The mounted secure IC/flash memory controller 302 can be connected by wire bonding, flip chip, substrate embedding, and the like. Further, it may be adapted to an ISO pad with the expansion terminal.

Further, it is desired that electrical contact is ensured on the surface of the connector terminals 605 by gold plating and the like.

FIG. 10 is a full view showing the structure of the mini UICC adaptor 305b.

FIG. 10A is a plan view of the rear surface side of the mini UICC adaptor 305b, FIG. 10B is a plan view of the front surface side of the mini UICC adaptor 305b, FIG. 10C is a side view of the mini UICC adaptor 305b, and FIG. 10D is a cross sectional view along the line D-D' of FIG. 10B. Further, FIG. 10E is a perspective view showing the external appearance on the rear surface side of the mini UICC adaptor 305b, and FIG. 10F is a perspective view showing the external appearance on the front surface side of the mini UICC adaptor 305b.

The mini UICC adaptor 305b incorporates the secure IC/flash memory controller 302 and the like in a substrate 1001, and the substrate 1001 is covered with a metal frame guide 1002. A space for inserting the flash memory card 306, that is, a slot 1003 is provided between the substrate 1001 and the metal frame guide 1002. On the surface of the substrate 1001, a plurality of ISO7816 electrodes 1004 for the ISO7816 I/F 304 are arranged. In the slot 1003, a plurality of connecter terminals 1005 for the flash card I/F 307 are arranged on the substrate 1001. The connecter terminals 1005 may be formed by plating process or may be multi-contact terminals having plural contacts per one terminal so as to guarantee contact certainty.

Further, the secure IC/flash memory controller 302 can have a sandwich structure in which it is embedded inside the substrate or molded on the substrate. In the figure, the contact between the card terminals 503 and the connecter terminals 1005 is shown by the dashed line. Also, the part (here, substrate 501) on the side face of the flash memory card 306 with a reduced thickness is inserted into the guide of the slot and retained therein. At this time, the sealing resin 502 is exposed from the opening of the metal plate 603.

Further, the top end of the metal frame guide 1002 may be covered with insulating resin to prevent the unnecessary electrical short-circuit to the host equipment like in the case of the Plug-in SIM adaptor 305a. Further, the above-described metal frame guide 1002 and metal plate 603 are basically formed of a metal plate to secure the strength, but they can be formed by the plastic resin having high strength instead.

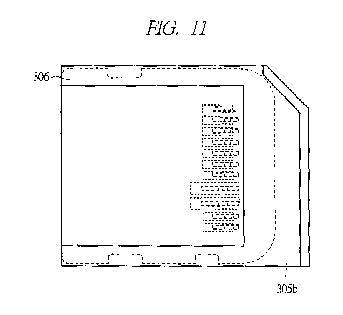

FIG. 11 is a plan view showing an outer shape after inserting the flash memory card 306 into the mini UICC adaptor 305b.

The dotted line shows the position of the inserted flash memory card 306. The mini UICC adaptor 305b may be provided with a mechanical latch using the notches 504 of the flash memory card 306 and a presence detect SW for preventing detachment or detecting the card.

FIG. 12 is a full view showing the structure of a memory stick micro adaptor 305C. FIG. 12A is a plan view of the front surface of the memory stick micro adaptor 305c, FIG. 12B is a plan view of the rear surface of the memory stick micro adaptor 305c, and FIG. 12C is a side view of the memory stick micro adaptor 305c.

The memory stick micro adaptor 305c has a thin type card insertion part 1201, notches 1202, and the like for inserting the flash memory card 306. The memory stick micro adaptor 305c is entirely constituted of the metal frame. It is also possible to form the metal frame by coating its surface with the insulating resin. Further, the adaptor may be formed by the plastic resin having high strength instead of the metal frame. Further, it can be formed by the insert molding in which a thin part for retaining the front surface and the side face of the flash memory card 306 is formed of the metal frame and the top end part and the thick part are formed of plastic molding.

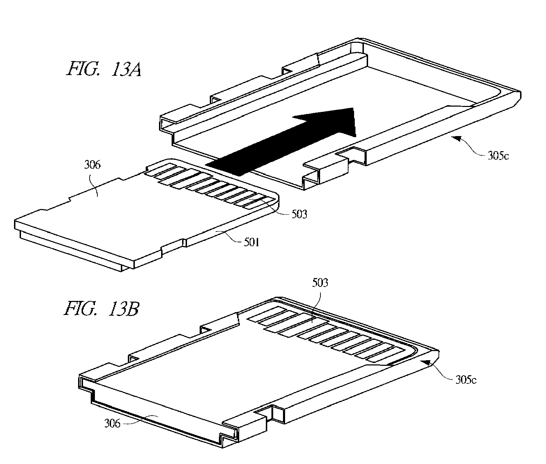

FIG. 13 is a full view showing a method for loading the flash memory card 306 into the memory stick micro adaptor 305c. FIG. 13A is a view showing the state before loading the flash memory card 306, and FIG. 13B is a view showing the state after loading the flash memory card 306.

The substrate 501 is guided and retained by the U-shaped part on the side face of the memory stick micro adaptor 305c. The sealing resin 502 is contained in the card insertion part 1201. More specifically, this memory stick micro adaptor 305c performs only the conversion of the physical geometric dimensions.

Further, the flash memory card 306 is guided by the side face in the insertion direction, and the part corresponding to the notch 504 is formed also on the side face of the memory stick micro adaptor 305c.

Further, when the part corresponding to the notch 504 of the flash memory card 306 is not provided on the side face of the memory stick micro adaptor 305c, the notch 504 of the flash memory card 306 is placed under the metal frame of the memory stick micro adaptor 305c and is not exposed.

### (Second Embodiment)

In the present embodiment, an example of a flash memory card 307 obtained by adding connector terminals 1401 to the flash memory card 306 shown in the first embodiment is shown. Since other configuration and advantages are the same as those of the first embodiment, the description thereof will be omitted.

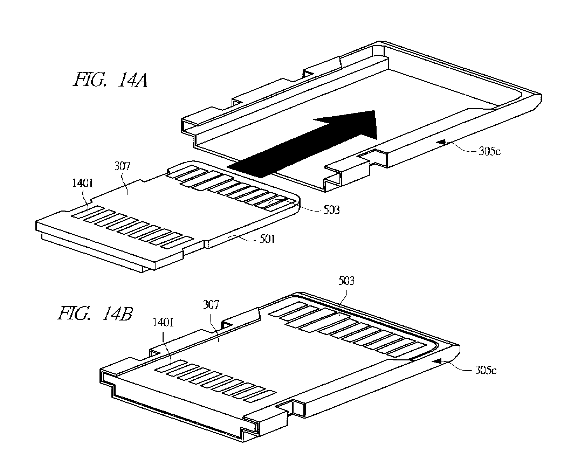

FIG. 14 is a full view showing a method for loading another flash memory card to the memory stick micro adaptor 305c. FIG. 14A is a view showing the state before loading the flash memory card 307, and FIG. 14B shows the state after loading the flash memory card 307.

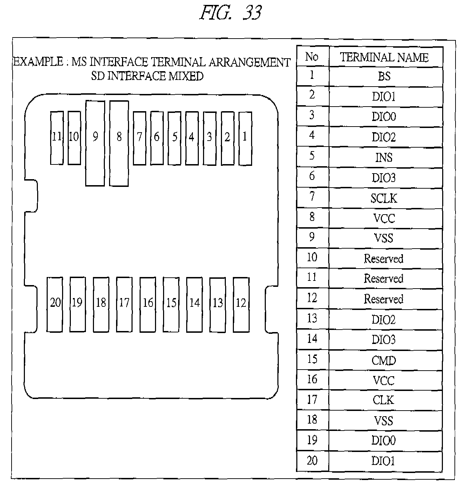

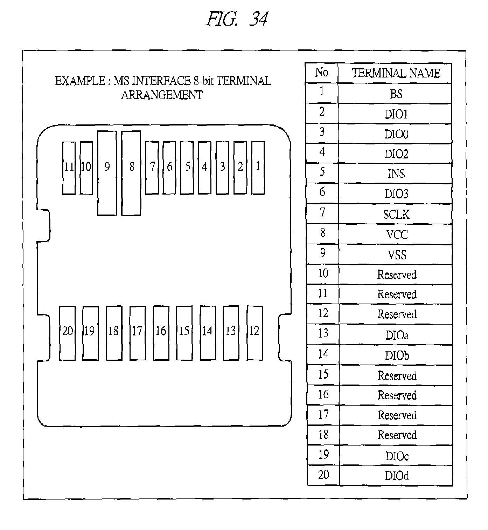

The flash memory card 307 loaded on the memory stick micro adaptor 305c is added with the connecter terminals 1401. More specifically, the connecter terminals 1401 of a second row are arranged on the back side of the flash memory card 307. The connecter terminals 1401 of the second row may be used as the terminals for the expansion of the 8-bit data width or may be used for the I/F of a SD card, I/F of a MMC card and I/F of a secure IC card. The function of each terminal are shown in, for example, FIG. 33 and FIG. 34.

In the example shown in FIG. 33, the terminals No. 1 to 11 of the first row have the terminal arrangement corresponding to the I/F of a memory stick, and the terminals No. 12 to 20 of the second row have the terminal arrangement corresponding to the I/F of a SD card. More specifically, in the arrangement of the terminals of the first row, No. 1 is for BS, No. 2 is for DIO1 (data input/output), No. 3 is for DIO0 (data input/output), No. 4 is for DIO2 (data input/output), No. 5 is for INS, No. 6 is for DIO3 (data input/output), No.7 is for SCLK (clock), No. 8 is for VCC (power supply), No. 9 is for VSS (ground), No. 10 and No. 11 are for Reserved. Further, in the arrangement of the terminals of the second row, No. 12 is for Reserved, No. 13 is for DIO2 (data input/output), No. 14 is for DIO3 (data input/output), No. 15 is for CMD (command), No. 16 is for VCC (power supply), No. 17 is for CLK (clock), No. 18 is for VSS (ground), No. 19 is for DIO0 (data input/output), and No. 20 is for DIO1 (data input/putput).

Further, the example in FIG. 34 shows the terminal arrangement corresponding to the I/F of the 8-bit memory stick. More specifically, No. 1 is for BS, No. 2 is for DIO1 (data input/output), No. 3 is for DIO0 (data input/output), No. 4 is for DIO2 (data input/putput), No. 5 is for INS, No. 6 is for DIO3 (data input/output), No. 7 is for SCLK (clock), No. 8 is for VCC (power supply), No. 9 is for VSS (ground), No. 10 to No. 12 are for Reserved, No. 13 is for DIOa (data input/output), No. 14 is for DIOb (data input/output), No. 15 to No. 18 are for Reserved, No. 19 is for DIOc (data input/output), and No. 20 is for DIOd (data input/output). Here, similar to the connecter terminals shown in FIG. 32 of the first embodiment, the reserved terminals can be used as expansion terminals for the realization of a USB interface, the realization of MMC or serial interface, and the like.

Further, though not particularly illustrated, test terminals may be provided also in the present embodiment like in the first embodiment. The function of the test terminals is the same as that of the above-described embodiment. As for the arrangement positions of the test terminals, they are provided in an area between the terminals of the first row and the terminals of the second row. These test terminals are usually covered with an insulating seal and a solder resist and are made unusable like in the first embodiment.

### (Third Embodiment)

FIG. 15 is a full view showing a flash memory card 308 which is another structural example of the flash memory card 306 according to the first embodiment.

FIG. 15A is a plan view of the front surface of the flash memory card 308, FIG. 15B is a plan view of the rear surface of the flash memory card 308, FIG. 15C is a left side view of the flash memory card 308, FIG. 15D is a right side view of the flash memory card 308, FIG. 15E is a front view of the flash memory card 308, and FIG. 15F is a back view of the flash memory card 308. Further, FIG. 15G is a perspective view showing the external appearance on the front surface side of the flash memory card 308, and FIG. 15H is a perspective view showing the external appearance on the rear surface side of the flash memory card 308.

In the flash memory card 308 of FIG. 15, for the flash memory card 306 of FIG. 5, the area of the mold 502 on the front side on the front surface of the card is slightly narrowed down to form a step with the substrate 501 so that the substrate 501 is exposed, and connecter terminals 1501 for SIM are additionally provided on the substrate 501 on the mold 502 side.

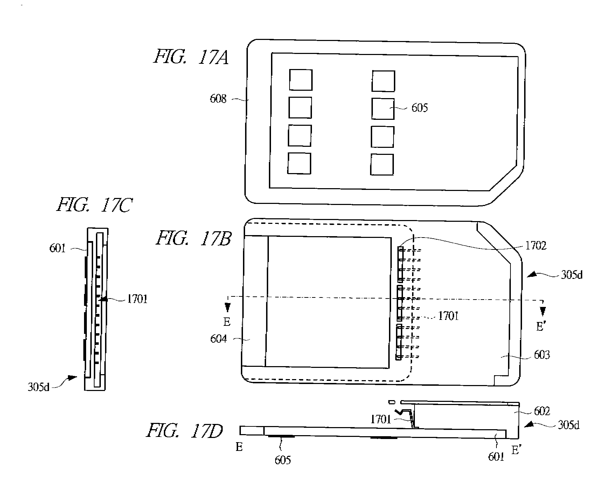

The connection between this flash memory card 308 and a Plug-in SIM adaptor and a mini UICC adaptor will be described below in detail in the description of a fourth embodiment with reference to FIG. 17. Since other configuration and advantages are the same as those of the first embodiment, the description thereof will be omitted.

### (Fourth Embodiment)

FIG. 16 is a full view showing a flash memory card 309 which is another structural example of the flash memory card 308 according to the third embodiment.

FIG. 16A is a plan view of the front surface of the flash memory card 309, FIG. 16B is a plan view of the rear surface of the flash memory card 309, FIG. 16C is a left side view of the flash memory card 309, FIG. 16D is a right side view of the flash memory card 309, FIG. 16E is a front view of the flash memory card 309, and FIG. 16F is a back view of the flash memory card 309. Further, FIG. 16G is a perspective view showing the external appearance on the front surface side of the flash memory card 309, and FIG. 16H is a perspective view showing the external appearance on the rear surface side of the flash memory card 309.

In the flash memory card 309 of FIG. 16, for the flash memory card 308 of FIG. 15, connecter terminals 1601 are additionally provided on the surface of the substrate 501. More specifically, the connecter terminals 1601 of a second row are arranged on the back side of the flash memory card 309. These connecter terminals 1601 of the second row may be used as the terminals for the expansion of the 8-bit data width or may be used for the I/F of a SD card, I/F of a MMC card and I/F of a secure IC card. Further, the function of each terminal is the same as that described in the second embodiment, and the same advantages can be obtained. Since other configuration and advantages are the same as those of the first embodiment, the description thereof will be omitted.

FIG. 17 is a full view showing a Plug-in SIM adaptor 305d which is another structural example of the Plug-in SIM adaptor 305a shown in the first embodiment.

FIG. 17A is a plan view of the rear surface side of the Plug-in SIM adaptor 305d, FIG. 17B is a plan view of the front surface side of the Plug-in SIM adaptor 305d, FIG. 17C is a side view of the Plug-in SIM adaptor 305d, and FIG. 17D is a cross sectional view along the line E-E' of FIG. 17B.

The Plug-in SIM adaptor 305d of FIG. 17 is an adaptor compatible with a card having connecter terminals on its both surfaces like the flash memory cards 308 and 309 of FIG. 15 and FIG. 16. In the Plug-in SIM adaptor 305c of FIG. 17, for the Plug-in SIM adaptor 305a of FIG. 6, connecter terminals 606 are replaced with connecter terminals 1701. The connecter terminals 1701 are brought into contact with the connecter terminals 1501 of the flash memory cards 308 and 309 at the time of inserting the flash memory cards 308 and 309. This connecter terminal is different in shape from the connecter terminal 606 of FIG. 6, and its one end is covered and fixed by sealing resin in the module area 602 and the other end is provided at a position (position close to the rear surface side) higher than the center of the Plug-in SIM adaptor 305d in the thickness direction.

Further, holes 1702 are formed in the metal plate 603. There is the possibility that electrical short-circuit occurs due to the contact between the metal plate 603 and the connector 1701 because the connecter terminals 1701 move in the thickness direction when the flash memory cards 308 and 309 are inserted. Therefore, the openings are formed in a part of the metal plate 603 so that the metal plate 603 and the connecter terminals 1701 are not brought into contact with each other.

Further, the surface of the metal plate 603 may be coated with the insulating resin like in the first embodiment. In this case, the electrical short-circuit can be prevented even when the metal plate 603 and the connecter terminals 1701 are brought into contact with each other.

FIG. 18 is a full view showing a mini UICC adaptor 305e which is another structural example of the mini UICC adaptor 305b shown in the first embodiment.

FIG. 18A is a plan view of the rear surface side of the mini UICC adaptor 305e, FIG. 18B is a plan view of the front surface side of the mini UICC adaptor 305e, FIG. 18C is a side view of the mini UICC adaptor 305e, and FIG. 18D is a cross sectional view along the line F-F' of FIG. 18B. Further, FIG. 18E is a perspective view showing the external appearance on the rear surface side of the mini UICC adaptor 305e, and FIG. 18F is a perspective view showing the external appearance on the front surface side of the mini UICC adaptor 305e.

The mini UICC adaptor 305e of FIG. 18 is an adaptor compatible with a card having connecter terminals on its both surfaces like the flash memory cards 308 and 309 of FIG. 15 and FIG. 16. In the mini UICC adaptor 305e of FIG. 18, for the mini UICC adaptor 305b of FIG. 10, the connecter terminals 1005 are changed to connecter terminals 1801. The connecter terminals 1801 are brought into contact with the connecter terminals 1501 of the flash memory cards 308 and 309 at the time of inserting the flash memory cards 308 and 309. Further, a metal frame guide 1002 has holes 1802 opened therein. The function of the holes 1802 is the same as that of the holes 1702. Further, the surface of this frame guide 1002 of the mini UICC adaptor 305e can be coated with the insulating resin like the metal plate 603, and the same advantages can be obtained.

### (Fifth Embodiment)

FIG. 19 is a full view showing a flash memory card 310 which is another structural example of the flash memory card 306 according to the first embodiment.

FIG. 19A is a plan view of the front surface of the flash memory card 310, FIG. 19B is a plan view of the rear surface of the flash memory card 310, FIG. 19C is a left side view of the flash memory card 310, FIG. 19D is a right side view of the flash memory card 310, FIG. 19E is a front view of the flash memory card 310, and FIG. 19F is a back view of the flash memory card 310. Further, FIG. 19G is a perspective view showing the external appearance on the front surface side of the flash memory card 310, and FIG. 19H is a perspective view showing the external appearance on the rear surface side of the flash memory card 310.

In the flash memory card 310 of FIG. 19, for the flash memory card 306 of FIG. 5, the step with the substrate 501 is eliminated by expanding the area of the mold 502, thereby making a mold 1901 equal in size to the substrate 501. This structure of the flash memory card 310 can be obtained by, for example, molding a plurality of cards at once into a sheet-like shape, and then cutting them into pieces of cards by water jet, laser and others. At this time, since the mold forming by planar cavities is possible, the manufacturing process is facilitated.

Further, it is also possible to form the mold 1901 not by a sealing resin, but by the wiring board. At this time, the secure IC and the controller chip of the flash memory are configured to be embedded in the wiring board.

Since other configuration and advantages are the same as those of the first embodiment, the description thereof will be omitted.

### (Sixth Embodiment)

FIG. 20 is a full view showing a flash memory card 311 which is another structural example of the flash memory card 310 according to the fifth embodiment.

FIG. 20A is a plan view of the front surface of the flash memory card 311, FIG. 20B is a plan view of the rear surface of the flash memory card 311, FIG. 20C is a left side view of the flash memory card 311, FIG. 20D is a right side view of the flash memory card 311, FIG. 20E is a front view of the flash memory card 311, and FIG. 20F is a back view of the flash memory card 311. Further, FIG. 20G is a perspective view showing the external appearance on the front surface side of the flash memory card 311, and FIG. 20H is a perspective view showing the external appearance on the rear surface side of the flash memory card 311.

In the flash memory card 311 of FIG. 20, for the flash memory card 310 of FIG. 19, connecter terminals 1601 are additionally provided on the surface of the substrate 501. More specifically, the connecter terminals 1601 of a second row are arranged on the back side of the flash memory card 311. The function of each terminal is the same as that described in the second embodiment, and the same advantages can be obtained. Since other configuration and advantages are the same as those of the fifth embodiment, the description thereof will be omitted.

### (Seventh Embodiment)

FIG. 21 is a full view showing a flash memory card 312 which is another structural example of the flash memory card 306 according to the first embodiment.

FIG. 21A is a plan view of the front surface of the flash memory card 312, FIG. 21B is a plan view of the rear surface of the flash memory card 312, FIG. 21C is a left side view of the flash memory card 312, FIG. 21D is a right side view of the flash memory card 312, FIG. 21E is a front view of the flash memory card 312, and FIG. 21F is a back view of the flash memory card 312. Further, FIG. 21G is a perspective view showing the external appearance on the front surface side of the flash memory card 312, and FIG. 21H is a perspective view showing the external appearance on the rear surface side of the flash memory card 312.

In the flash memory card 312 of FIG. 21, for the flash memory card 306 of FIG. 5, a mold 2101 is formed by providing a step on the front side of the mold 502 on the surface of the card. The step of the mold 2101 is provided on the rear side part of the connecter terminals 503. By this means, the connecter terminals 606 of the Plug-in SIM adaptor and the mini UICC adaptor can be prevented from being touched by person's fingers.

The card in which the thickness of the sealing resin on the front side on the surface of the card is reduced like in the flash memory card 312 according to the present embodiment and the card in which the sealing resin is not formed on the front side on the surface of the card like in the third and the fourth embodiments are **characterized in that** the front side thereof can be covered with a metal frame at the time of being inserted into the Plug-in SIM adaptor or the mini UICC adaptor. If the connecter terminals of the Plug-in SIM adaptor or the mini UICC adaptor are formed directly below this covered part, a part or all of the connecter terminals can be covered. By this means, the connecter terminals can be protected from damages due to finger nails at the time of inserting the flash memory card or obstacles at the time of dropping the card and others. For example, when the mini UICC adaptor 305e of FIG. 18 is prepared as an adaptor for the flash memory card 312 according to the present embodiment, the connecter terminals 1801 of the mini UICC adaptor 305e can be covered with the metal frame 1002 except the holes 1802. Further, when the mini UICC adaptor 305b of FIG. 10 is prepared as an adaptor for the flash memory card 312 according to the present embodiment, since a step is provided on the front side on the surface of the flash memory card 312, the metal frame 1002 can be expanded to the back side until reaching the position where the connecter terminals 1005 are covered.

Further, since other configuration and advantages are the same as those of the first embodiment, the description thereof will be omitted.

### (Eighth Embodiment)

FIG. 22 is a full view showing a flash memory card 313 which is another structural example of the flash memory card 312 according to the seventh embodiment.

FIG. 22A is a plan view of the front surface of the flash memory card 313, FIG. 22B is a plan view of the rear surface of the flash memory card 313, FIG. 22C is a left side view of the flash memory card 313, FIG. 22D is a right side view of the flash memory card 313, FIG. 22E is a front view of the flash memory card 313, and FIG. 21F is a back view of the flash memory card 313. Further, FIG. 22G is a perspective view showing the external appearance on the front surface side of the flash memory card 313, and FIG. 22H is a perspective view showing the external appearance on the rear surface side of the flash memory card 313.

In the flash memory card 313 of FIG. 22, for the flash memory card 312 of FIG. 21, connecter terminals 1601 are additionally provided on the surface of the substrate 501. More specifically, the connecter terminals 1601 of a second row are arranged on the back side of the flash memory card 313. The function of each terminal is the same as that described in the second embodiment, and the same advantages can be obtained. Also, since other configuration and advantages are the same as those of the seventh embodiment, the description thereof will be omitted.

### (Ninth Embodiment)

FIG. 23 is a full view showing a flash memory card 314 which is another structural example of the flash memory card 306 according to the first embodiment.

FIG. 23A is a plan view of the front surface of the flash memory card 314, FIG. 23B is a plan view of the rear surface of the flash memory card 314, FIG. 23C is a left side view of the flash memory card 314, FIG. 23D is a right side view of the flash memory card 314, FIG. 23E is a front view of the flash memory card 314, and FIG. 23F is a back view of the flash memory card 314. Further, FIG. 23G is a perspective view showing the external appearance on the front surface side of the flash memory card 314, and FIG. 23H is a perspective view showing the external appearance on the rear surface side of the flash memory card 314.

In the flash memory card 314 of FIG. 23, for the flash memory card 306 of FIG. 5, a mold 2301 is formed by providing steps on the right side and the left side of the mold 502 on the surface of the card.

Here, when the capacity of the flash memory card 306 needs to be increased, a scheme of stacking the flash memory chips and others is conceivable. Further, it is also conceivable to increase the area of the flash memory chip by stacking the flash memory chip and the controller chip. However, since the total thickness of the card is physically increased in that case, it is necessary to reduce the thickness of the substrate 501. Thus, by providing the steps on the right side and the left side of the mold on the surface of the card like in the present embodiment, the strength of both sides of the flash memory card 314 can be maintained at the time of inserting it into the Plug-in SIM adaptor and the mini UICC adaptor. Since other configuration and advantages are the same as those of the first embodiment, the description thereof will be omitted.

### (Tenth Embodiment)

FIG. 24 is a full view showing a flash memory card 315 which is another structural example of the flash memory card 314 according to the ninth embodiment.

FIG. 24A is a plan view of the front surface of the flash memory card 315, FIG. 24B is a plan view of the rear surface of the flash memory card 315, FIG. 24C is a left side view of the flash memory card 315, FIG. 24D is a right side view of the flash memory card 315, FIG. 24E is a front view of the flash memory card 315, and FIG. 24F is a back view of the flash memory card 315. Further, FIG. 24G is a perspective view showing the external appearance on the front surface side of the flash memory card 315, and FIG. 24H is a perspective view showing the external appearance on the rear surface side of the flash memory card 315.

In the flash memory card 315 of FIG. 24, for the flash memory card 314 of FIG. 23, connecter terminals 1601 are additionally provided on the surface of the substrate 501. More specifically, the connecter terminals 1601 of a second row are arranged on the back side of the flash memory card 315. The function of each terminal is the same as that described in the second embodiment, and the same advantages can be obtained. Also, since other configuration and advantages are the same as those of the ninth embodiment, the description thereof will be omitted.

### (Eleventh Embodiment)

FIG. 25 is a full view showing a flash memory card 316 which is another structural example of the flash memory card 314 according to the ninth embodiment.

FIG. 25A is a plan view of the front surface of the flash memory card 316, FIG. 25B is a plan view of the rear surface of the flash memory card 316, FIG. 25C is a left side view of the flash memory card 316, FIG. 25D is a right side view of the flash memory card 316, FIG. 25E is a front view of the flash memory card 316, and FIG. 25F is a back view of the flash memory card 316. Further, FIG. 25G is a perspective view showing the external appearance on the front surface side of the flash memory card 316, and FIG. 25H is a perspective view showing the external appearance on the rear surface side of the flash memory card 316.

In the flash memory card 316 of FIG. 25, for the flash memory card 306 of FIG. 23, a mold 2501 is formed by providing a step on the front side of the mold 2301 on the surface of the card. The purpose of providing the step of the mold 2301 is the same as that for the step of the mold 2101 described in the seventh embodiment, and the same advantages can be obtained. Since other configuration and advantages are the same as those of the ninth embodiment, the description thereof will be omitted.

### (Twelfth Embodiment)

FIG. 26 is a full view showing a flash memory card 317 which is another structural example of the flash memory card 316 according to the eleventh embodiment.

FIG. 26A is a plan view of the front surface of the flash memory card 317, FIG. 26B is a plan view of the rear surface of the flash memory card 317, FIG. 26C is a left side view of the flash memory card 317, FIG. 26D is a right side view of the flash memory card 317, FIG. 26E is a front view of the flash memory card 317, and FIG. 26F is a back view of the flash memory card 317. Further, FIG. 26G is a perspective view showing the external appearance on the front surface side of the flash memory card 317, and FIG. 26H is a perspective view showing the external appearance on the rear surface side of the flash memory card 317.

In the flash memory card 317 of FIG. 26, for the flash memory card 316 of FIG. 25, connecter terminals 1601 are additionally provided on the surface of the substrate 501. More specifically, the connecter terminals 1601 of a second row are arranged on the back side of the flash memory card 317. The function of each terminal is the same as that described in the second embodiment, and the same advantages can be obtained. Also, since other configuration and advantages are the same as those of the eleventh embodiment, the description thereof will be omitted.

### (Thirteenth Embodiment)

FIG. 27 is a full view showing a flash memory card 318 which is another structural example of the flash memory card 306 according to the first embodiment.

FIG. 27A is a plan view of the front surface of the flash memory card 318, FIG. 27B is a plan view of the rear surface of the flash memory card 318, FIG. 27C is a left side view of the flash memory card 318, FIG. 27D is a right side view of the flash memory card 318, FIG. 27E is a front view of the flash memory card 318, and FIG. 27F is a back view of the flash memory card 318. Further, FIG. 27G is a perspective view showing the external appearance on the front surface side of the flash memory card 318, and FIG. 27H is a perspective view showing the external appearance on the rear surface side of the flash memory card 318.

In the flash memory card 318 of FIG. 27, for the flash memory card 306 of FIG. 5, a mold 2701 is formed by moving the area of the mold 502 on the front side on the surface of the card toward the back side. More specifically, a step is provided between the mold 2701 and the substrate 501 so as to expose the substrate 501. The purpose of providing the step is the same as that for the step of the mold 2101 described in the seventh embodiment, and the same advantages can be obtained. Since other configuration and advantages are the same as those of the first embodiment, the description thereof will be omitted.

### (Fourteenth Embodiment)

FIG. 28 is a full view showing a flash memory card 319 which is another structural example of the flash memory card 318 according to the thirteenth embodiment.

FIG. 28A is a plan view of the front surface of the flash memory card 319, FIG. 28B is a plan view of the rear surface of the flash memory card 319, FIG. 28C is a left side view of the flash memory card 319, FIG. 28D is a right side view of the flash memory card 319, FIG. 28E is a front view of the flash memory card 319, and FIG. 28F is a back view of the flash memory card 319. Further, FIG. 28G is a perspective view showing the external appearance on the front surface side of the flash memory card 319, and FIG. 28H is a perspective view showing the external appearance on the rear surface side of the flash memory card 319.

In the flash memory card 319 of FIG. 28, for the flash memory card 317 of FIG. 25, connecter terminals 1601 are additionally provided on the surface of the substrate 501. More specifically, the connecter terminals 1601 of a second row are arranged on the back side of the flash memory card 319. The function of each terminal is the same as that described in the second embodiment, and the same advantages can be obtained. Also, since other configuration and advantages are the same as those of the thirteenth embodiment, the description thereof will be omitted.

### (Fifteenth Embodiment)

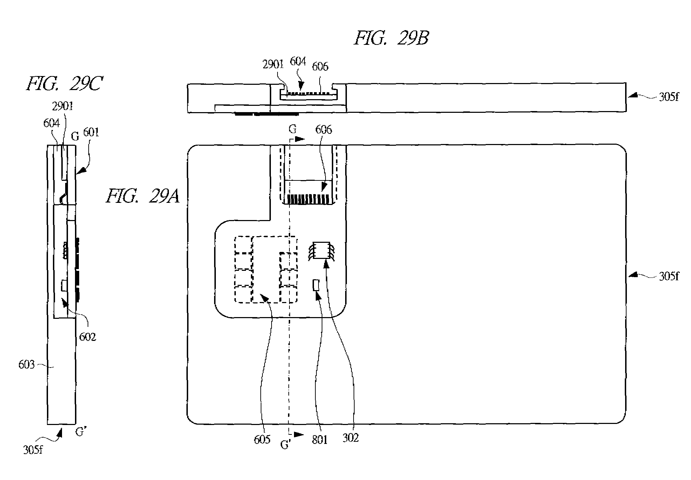

FIG. 29 is a full view showing the structure of a smart card (ID-1) conversion adaptor 305f in which the flash memory card described in each of the embodiments according to the present invention can be inserted. FIG. 29A is a plan view of the front surface of the smart card (ID-1) conversion adaptor 305f, FIG. 29B is a side view of the smart card (ID-1) conversion adaptor 305f, and FIG. 29C is a cross sectional view along the line G-G' of FIG. 29A.

For example, the smart card (ID-1) conversion adaptor 305f of FIG. 29 is for the use of the smart card. The smart card (ID-1) conversion adaptor 305f of FIG. 29 has a module area 602 mounted with the secure IC/flash memory controller 302, chip parts 801, and the like on the substrate 601, and the module area 602 is covered with the metal plate 603. Between the substrate 601 and the metal plate 603, a space, that is, the slot 604 for inserting the flash memory card 306 is provided. Further, a connecter part of the slot 604 has a space 2901. By this space 2901, the connecter terminals can be stroked in the card thickness direction.

On the surface of the substrate 601, a plurality of ISO7816 electrodes 605 for an ISO7816 I/F 304 are arranged. In the slot 604, a plurality of connecter terminals 606 for a flash card I/F 307 are arranged on the substrate 601. The connecter terminals 606 may be plated with Au (gold) or be multi-contact terminals having plural contacts per one terminal so as to guarantee contact certainty.

### (Sixteenth Embodiment)

Next, the securement of data security of a secure area between the secure IC (SIC) of the Plug-in SIM adaptor and the mini UICC adaptor described in each of the embodiments of the present invention and the flash memory card described in each of the embodiments will be described.

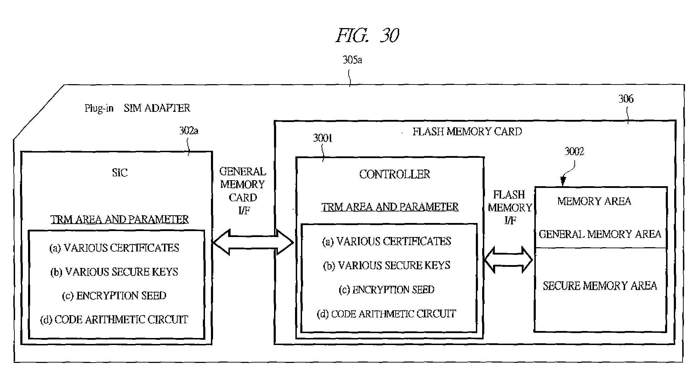

FIG. 30 is a block diagram showing a system configuration example of the IC card according to the first embodiment of the present invention.

A method for realizing the safe operations of the Plug-in SIM adaptor 305a mounted with the SIC using the memory area of the inserted flash memory card 306 as a secure memory area will be described.

Since a SIC 302a and the flash memory card 306 exchange data and commands through connecter terminals, security communication measures for preventing interceptions and others are indispensable like general communication lines.

In the SIC 302a of the Plug-in SIM adaptor 305a and in the controller 3001 of the flash memory card 306, a tamper resistant area referred to as TRM (tamper Resistant Module) necessary for security is provided according to need.

This TRM area contains the following information.
(a) Various certificates necessary for security: a route certificate of Certificate Authority (CA) generally certifying that a communication route is correct and a certificate certifying that a key to be the basis of encryption is correct are provided. Here, the certificate of the SIC 302a is taken as A, and the certificate of the controller 3001 is taken as B.
(b) Various secure keys: a secret key not opened to public and a public key are taken as J and K by the SIC 302a and the controller 3001, respectively. These keys may be provided in plurality according to need.
(c) Encryption seed: the SIC 302a and the controller 3001 generally have the encryption seeds L and M for generating temporary encryption codes in communication sessions different every time. As the temporary codes, temporary codes always having a random nature are generated by the codes incorporated in the SIC 302a and the controller 3001 and a code generator circuit (not shown).
(d) Code arithmetic circuit: arithmetic circuits for performing encryption processing and decryption by the given codes are taken as F and G, respectively. It is preferable that the arithmetic circuits are disposed in the tamper resistant area, not in a parameter area, so as to prevent illicit decryption and analysis from the outside. Further, these circuits check the validity of public key with certificate and perform encryption operations necessary for mutual authentication.

Next, an example of the use of the secure area will be described.

A method for reading and writing the necessary program and data from and in the secure area of the flash memory card 306 by the SIC 302a will be described.
(1) The SIC 302a preferably performs device authentication for confirming whether the use of the flash memory card 306 is really permitted. For this purpose, the SIC 302a can execute a device authentication command by means of a general Trusted Device. Further, in the case of a memory stick PRO, it may conform to the use of a magic gate and other command system with the enhanced security. In the case of a SD card and a MMC card, they may conform to the use of a secure memory card. Further, by using a public-key encryption method, the confirmation can be made by using the certificate and the public key without being intercepted by the third party.
   Further, an APDU (Application Protocol Data Unit) conforming to a smart card ISO/IEC7816 may be directly used or indirectly used by encapsulation. Here, the encapsulation means performing the transmission and reception by enveloping the APDU in a command to be used.
(2) Thereafter, the SIC 302a may write and read the encrypted data as it is in and from the memory area for storing the secure data of the flash memory card 306. The secure data area is not necessarily indispensable, and can be realized by writing it in the general memory area. Nevertheless, since it is not preferable that the secure data area is easily deleted, formatted, displaced and copied, it is expressed as a secure data area in order to restrict and control them. This can be achieved also by forming a memory partition for the exclusive use of the secure in the flash memory card and performing a non-compliant memory management by the general command. However, the exchange using a temporary session key is effective for the command session so as to ensure the security.
(3) At this time, when the controller 3001 is not required at all to decrypt the secure data of the SIC 302a, the controller needs only to write and read the encrypted data as it is in and from the secure area. The decryption is processed by a code arithmetic unit in the SIC 302a. This is the case where the controller 3001 is not involved at all except for the storage control of the secure data.
(4) If the secure data of the SIC 302a is applied to other SIC and other flash memory card, the following method can be used. The SIC encrypts a decryption key of the secure data by using the public key of the controller, and delivers it to the controller. The public key of the controller used at this time is attached with a certificate from the Authority of Certificate, and it is safe to use the public key after verifying the legitimacy of the public key of the controller by using the public key of the Authority of Certificate stored in the TRM and the like by the SIC. However, the public key is not always necessary to be stored in the TRM. In this manner, the SIC can safely deliver the decryption key to the flash memory card subjected to a reliable device authentication (otherwise, the encryption is made with the public key of the final receiving device by the same method so as not to be decrypted by the controller). A secret key for the decryption encrypted by the public key of the controller is decrypted and safely stored in the TRM area in the controller.
(5) When other SIC and other flash memory card require the secure data of (4), the flash memory card is detached in a removable manner and is inserted into other Plug-in SIM adaptor, mini UICC adaptor, and memory card adaptor, and then, is subjected to mutual device authentication. After the authentication, by the public key delivered from other SIC and other flash memory card, the decryption key stored in the TRM of the controller is encrypted and delivered. The data encrypted by this secrete key is delivered. By this means, other SIC and other flash memory card can decrypt the encrypted data by their own secret key decrypted and delivered internally.

Next, the regulation of the memory area (classification of the secure area) will be described.

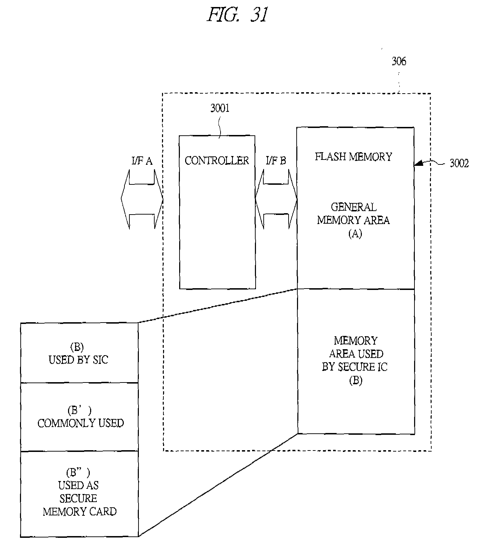

FIG. 31 is a view showing a memory map of the flash memory card 306.

The allotment of the memory is classified into the following four cases.
(Case 1) An area B can be used by the SIM only.
(Case 2) The area B can be commonly used by either of the SIM and the flash memory card.
(Case 3) The area B is divided into an area B' and an area B" and can be used by the SIM and the flash memory card, respectively.
(Case 4) Synthesis of (Case 1) and (Case 2)

The memory allotment is managed by the controller, and the method of the allotment includes: (1) the area is allotted by the internal condition of the controller at the time of card formatting; (2) the area is allotted by the formatting at the time of shipment; and (3) the area is allotted at the time of satisfying specific conditions by the secure command. An operation authority of a format of the secure area, data reading/writing, and display/non-display is managed by the method specified by the secure command of the memory card I/F. More specifically, a scheme that cannot be operated by the general user can be mounted.

The secure memory area B may be used in various applications depending on levels of the security such as (1) the encrypted data is recorded as it is, (2) the encrypted data and the encryption key are recorded, and (3) in the case of (2), the data is decoded by the encryption key, another encrypted key is generated for another device, and the encrypted data is exchanged. At this time, it is also possible to take security measures such as recording the encryption key in the specific area (TRM) in the controller.

The controller performs device authentication with the SIC of the SIM, and only when reliability and safety are ensured, the use thereof is permitted (prevention of mixing of illicit memory card). Further, by mounting the SIC on the flash memory card, it is possible to displace the SIM function of the SIC. Further, the secure processing for the exclusive use of the secure processing functions (authentication function, encryption processor, and the like) may be further simplified and implemented as a coprocessor.

### (Seventeenth Embodiment)

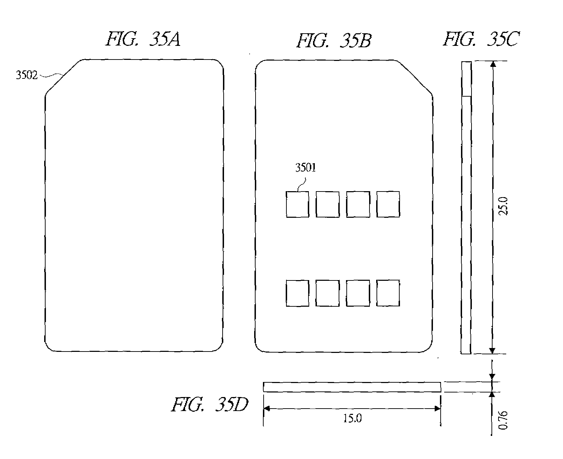

FIG. 35 is a full view showing the structure of a conventional Plug-in SIM card, and FIG. 35A is a bottom view, FIG. 35B is a plan view, FIG. 35C is a right side view, and FIG. 35D is a front view. As shown in FIG. 35, the conventional Plug-in SIM card has a structure of 25 mm in length, 15 mm in width, and 0.76 mm in thickness, and ISO7816 electrodes 3501 are arranged on one of its surfaces. Further, a chamfered part 3502 is provided at one of the four corners thereof.

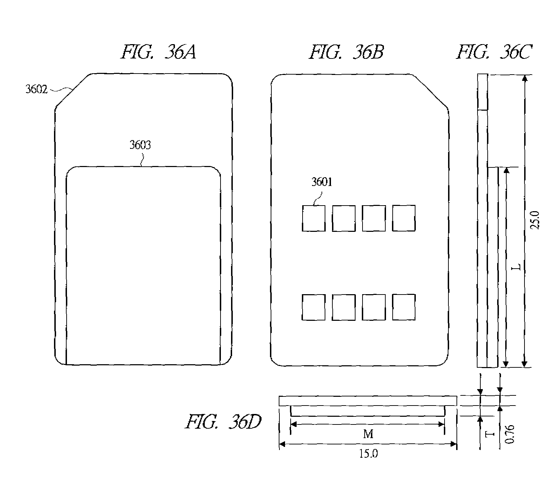

FIG. 36 is a full view showing a schematic structure of the Plug-in SIM card according to a seventeenth embodiment of the present invention, and FIG. 36A is a bottom view, FIG. 36B is a plan view, FIG. 36C is a right side view, and FIG. 36D is a front view. As shown in FIG. 36, ISO7816 electrodes 3601 are arranged on one of the surfaces of the Plug-in SIM card according to the seventeenth embodiment of the present invention. Further, a chamfered part 3602 is provided at one of the four corners thereof. The Plug-in SIM card according to the seventeenth embodiment has a structure of 25 mm in length and 15 mm in width, and also has a part with a thickness of 0.76 mm and a part 3603 with a thickness of T (T>0.76 mm). The part 3603 with the thickness of T is configured to be an approximately rectangular shape with a length of L (L<25 mm) and a width of M (M<15 mm), and only one side thereof contacts a profile line of the Plug-in SIM card. The right and left parts of the part 3603 with the thickness of T are located on the inner side from the right and left profile lines of the Plug-in SIM card, and the thickness of both sides of the card is 0.76 mm. This part with the thickness of 0.76 mm of both sides thereof is made to be fitted on a retainer part of the socket, so that the socket can be commonly used by the conventional Plug-in SIM card and the Plug-in SIM card according to the seventeenth embodiment. Further, as compared with the conventional Plug-in SIM card, since the Plug-in SIM card according to the seventeenth embodiment has a step formed by a thick part and a thin part, it can be easily caught by hand. Further, the part difficult to be mounted due to its large thickness can be mounted in the thick part.

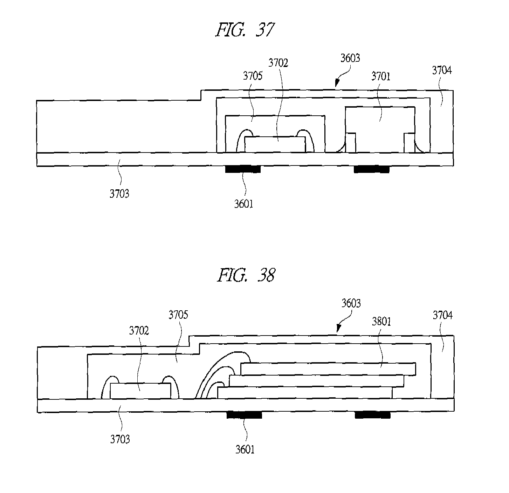

FIG. 37 is a cross sectional view showing the schematic structure of the Plug-in SIM card according to the seventeenth embodiment of the present invention. FIG. 37 shows an example in which a crystal oscillator 3701, a SIC chip 3702, and the like are mounted inside the part 3603 with the thickness of T.

As shown in FIG. 37, the Plug-in SIM card according to the seventeenth embodiment is constituted of, for example, the crystal oscillator 3701, the SIC chip 3702, a wiring board 3703, a resin cap 3704, a resin mold 3705, and the ISO7816 electrodes 3601. The crystal oscillator 3701 and the SIC chip 3702 are mounted inside the part 3603 with the thickness of T on the wiring board 3703. The crystal oscillator 3701 is solder-connected to a wiring pattern on the wiring board 3703. The SIC chip 3702 is connected to a wiring pattern on the wiring board 3703 by wiring bonding, and is resin-sealed by the resin mold 3705. These parts are covered with the resin cap 3704.

FIG. 38 is a cross sectional view showing the schematic structure of the Plug-in SIM card according to the seventeenth embodiment of the present invention. FIG. 38 shows an example in which stacked memory chips 3801 are mounted inside the part 3603 with the thickness of T.

As shown in FIG. 38, the Plug-in SIM card according to the seventeenth embodiment is constituted of, for example, the stacked memory chips 3801, the SIC chip 3702, the wiring board 3703, the resin cap 3704, the resin mold 3705, and the ISO7816 electrodes 3601. The stacked memory chips 3801 are mounted inside the part 3603 with the thickness of T on the wiring board 3703. The SIC chip 3702 is mounted in the part with the thickness of 0.76 mm. The stacked memory chips 3801 and the SIC chip 3702 are connected to the wiring pattern on the wiring board 3703 by wire bonding, and are resin-sealed by the resin mold 3705. These parts are covered with the resin cap 3704.

When the memory chips are stacked and mounted for the purpose of mounting a large capacity memory in the conventional Plug-in SIM card with the thickness of 0.76 mm, in the case where thick parts such as a crystal oscillator and a ceramic oscillator are mounted for the application of a USB-I/F, these parts often exceed the thickness of 0.76 mm of the conventional SIM card. Hence, the thickness of the SIM card is partly increased more than 0.76 mm in the thickness direction of the Plug-in SIM card, and these parts are mounted in the thick part, so that the SIM mounted with the large capacity memory and the SIM applicable to the USB-I/F can be realized. Note that the memory chip can be a single piece without being stacked. The advantage in this case is that a part of the Plug-in SIM card is easily grasped because of its large thickness.

### (Eighteenth Embodiment)

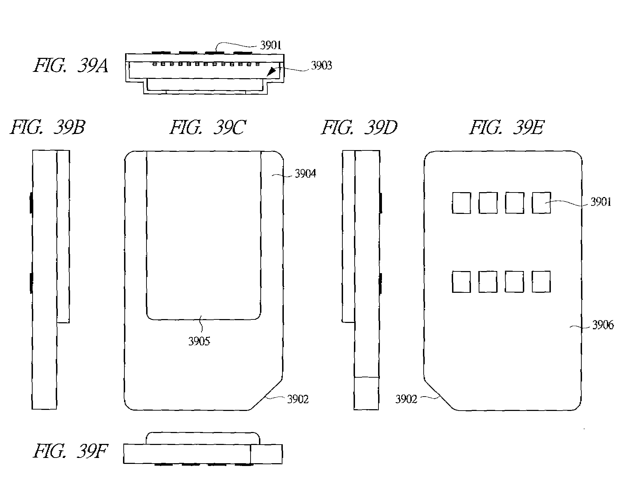

FIG. 39 is a full view showing a schematic structure of the partly thick Plug-in SIM adaptor according to an eighteenth embodiment of the present invention, and FIG. 39A is a back view, FIG. 39B is a left side view, FIG. 39C is a plan view, FIG. 39D is a right side view, FIG. 39E is a bottom view, and FIG. 39F is a front view. As shown in FIG. 39E, ISO7816 electrodes 3901 are arranged on one of the surfaces (substrate 3906) of the partly thick Plug-in SIM adaptor according to the eighteenth embodiment of the present invention. Further, a chamfered part 3902 is provided at one of the four corners. The Plug-in SIM adaptor according to the eighteenth embodiment has approximately the same shape and dimensions as those of the Plug-in SIM card according to the seventeenth embodiment. However, the Plug-in SIM adaptor according to the eighteenth embodiment has a slot 3903 for storing the memory card. The Plug-in SIM adaptor according to the eighteenth embodiment has a part 3904 with a thickness of 0.76 mm and a part 3905 with a thickness of T (T>0.76 mm). The part 3905 with the thickness of T is configured to be an approximately rectangular shape with a length of L (L<25 mm) and a width of M (M<15 mm), and only one side thereof contacts a profile line of the Plug-in SIM adaptor. The right and left parts of the part 3905 with the thickness of T are located on the inner side from the right and left profile lines of the Plug-in SIM adaptor, and the thickness of both sides of the adaptor is 0.76 mm. This part 3904 with the thickness of 0.76 mm of both sides is made to be fitted on a retainer part of the socket, so that the socket can be commonly used by the conventional Plug-in SIM card, the Plug-in SIM adaptor of the above-described embodiments, the Plug-in SIM card of the above-described embodiments, and the partly thick Plug-in SIM adaptor of the eighteenth embodiment. Further, as compared with the Plug-in SIM card of the above-described embodiments, since the Plug-in SIM adaptor according to the eighteenth embodiment has a step formed by a thick part and a thin part, it can be easily caught by hand.

A generally prevailing compact memory card includes M2 which is one type of a memory stick (registered trademark) micro, a micro SD (microSD: registered trademark) which is one type of a compact SD memory card (registered trademark) and others. These compact memory cards have a card thickness of approximately 1.2 mm (M2) and 1.0 mm (micro SD). On the other hand, the thicknesses of the Plug-in SIM adaptor and the Plug-in SIM card described in the above-described embodiments are approximately 0.76 mm. Consequently, the Plug-in SIM adaptor described in the above-described embodiments cannot store conventional memory cards such as M2 and micro SD.

Hence, as described in the eighteenth embodiment, the Plug-in SIM adaptor is formed into an adaptor partly having a thickness larger than that of the SIM adaptor, that is, 0.76 mm in a thickness direction of the SIM adaptor, so that the Plug-in SIM adaptor capable of mounting memory cards such as M2, micro SD, and others can be realized.

At this time, as the part to be thickened in the Plug-in SIM adaptor, an area not interfering with a SIM card retainer and a positioning mechanism of the socket is made thick, and the card retainer part is made to have the same thickness as that of the conventional Plug-in SIM card. By this means, it is possible to commonly use the socket with the conventional Plug-in SIM card.

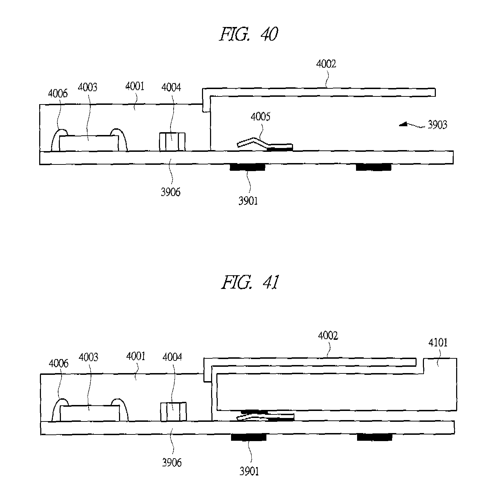

FIG. 40 is a cross sectional view showing the schematic structure of the partly thick Plug-in SIM adaptor (before a memory card is inserted) according to the eighteenth embodiment of the present invention. FIG. 41 is a cross sectional view showing the schematic structure of the partly thick Plug-in SIM adaptor (after a memory card is inserted) according to the eighteenth embodiment of the present invention. The partly thick Plug-in SIM adaptor according to the eighteenth embodiment of the present invention is constituted of, for example, a substrate 3906, ISO7816 electrodes 3901, a resin mold 4001, an upper retainer lid 4002, a SIC chip 4003, chip parts 4004, and connecter terminals 4005. The SIC chip 4003 is a chip provided with a secure function (SIC) and a memory card interface function and is wire-bonded to a wiring on the substrate 3906 by a bonding wire 4006. The chip parts 4004 are a passive element and an active element. The upper retainer lid 4002 is made of a metal plate and the like and has a step for enabling a standard memory card to be mounted. The connecter terminals 4005 are bonded to the wiring on the substrate 3906 by soldering, welding, and the like. A memory card 4101 is inserted into the slot 3903 of a thick part having the upper retainer lid 4002.

### (Nineteenth Embodiment)

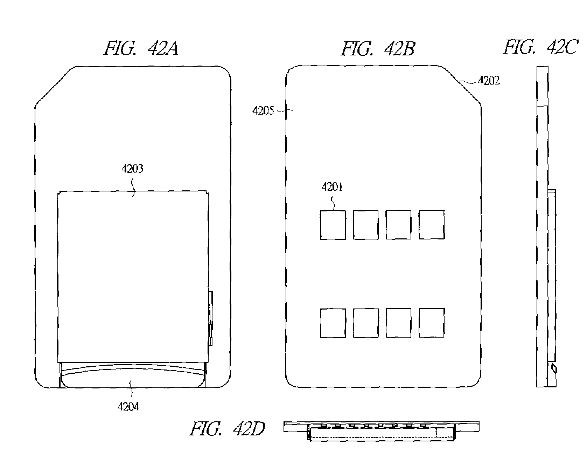

FIG. 42 is a full view showing the structure of a partly thick Plug-in SIM adaptor (for micro SD) according to a nineteenth embodiment of the present invention, and FIG. 42A is a bottom view, FIG. 42B is a plan view, FIG. 42C is a right side view, and FIG. 42D is a front view. FIG. 42 shows a view in which a micro SD card 4204 is inserted into the partly thick Plug-in SIM adaptor 4205. As shown in FIG. 42, ISO7816 electrodes 4201 are arranged on one of the surfaces of the partly thick Plug-in SIM adaptor 4205 according to the nineteenth embodiment of the present invention. Further, a chamfered part 4202 is provided at one of the four corners. A part of the upper retainer lid 4203 is made thick. The Plug-in SIM adaptor 4205 has approximately the same shape and dimensions as those of the Plug-in SIM adaptor according to the eighteenth embodiment. The micro SD card 4204 is inserted into the slot below the upper retainer lid 4203 of the Plug-in SIM adaptor 4205.

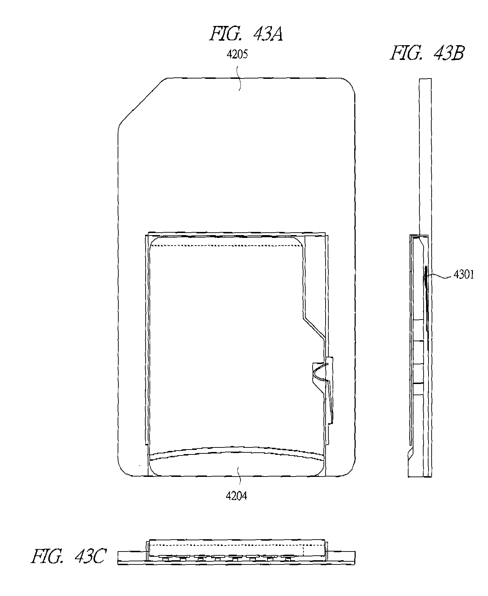

FIG. 43 is a full view showing the structure of the partly thick Plug-in SIM adaptor (for micro SD) except for an upper retainer lid according to the nineteenth embodiment of the present invention, and FIG. 43A is a plan view, FIG. 43B is a right side view, and FIG. 43C is a front view. FIG. 43 shows a view in which the micro SD card 4204 is inserted into the partly thick Plug-in SIM adaptor 4205. Connecter terminals 4301 in the slot of the Plug-in SIM adaptor 4205 are brought into contact with the terminals of the micro SD card 4204, so that both of them are electrically connected.

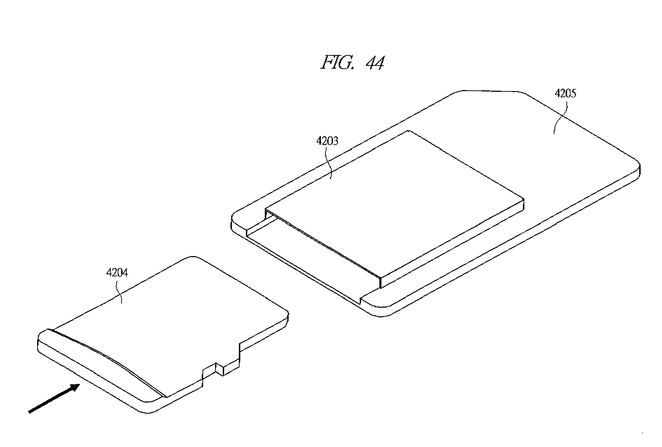

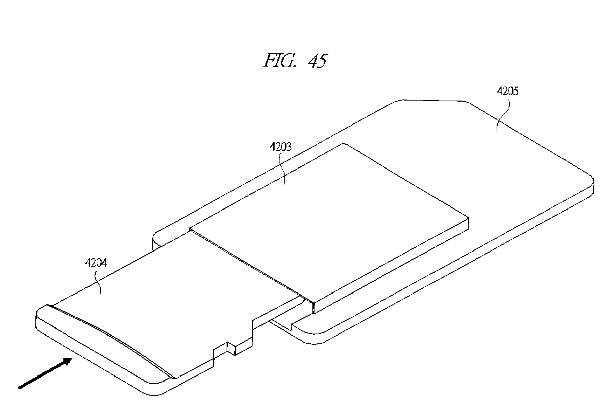

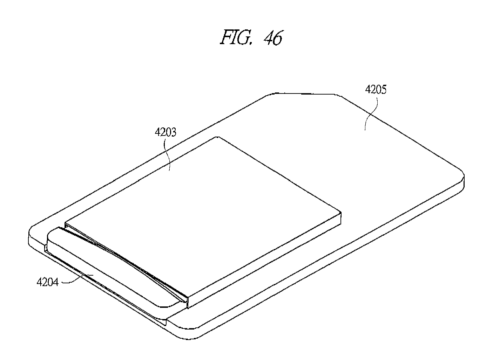

FIGs. 44, 45 and 46 are perspective views showing a state in which the micro SD card is inserted into the partly thick Plug-in SIM adaptor (for micro SD) according to the nineteenth embodiment of the present invention, and FIG. 44 shows a state before the insertion, FIG. 45 shows a state in the middle of the insertion, and FIG. 46 shows a state after the insertion. As shown in FIGs. 44, 45 and 46, the micro SD card 4204 is inserted into the slot below the upper retainer lid 4203 of the Plug-in SIM adaptor 4205.

### (Twentieth Embodiment)

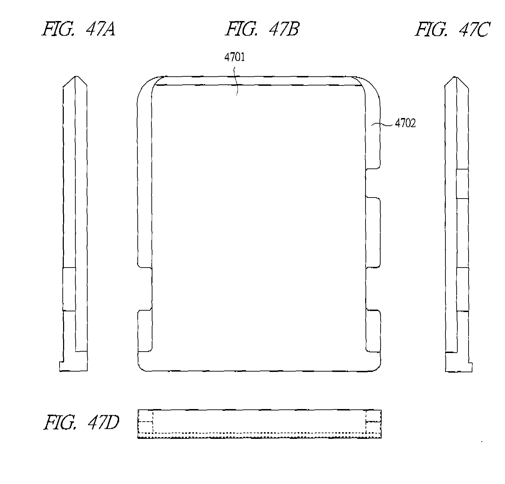

FIG. 47 is a view showing the outer shape of an ordinary M2 memory card, and FIG. 47A is a left side view, FIG. 47B is a plan view, FIG. 47C is a right side view, and FIG. 47D is a front view. As shown in FIG. 47, an ordinary M2 memory card has a part 4701 with a thickness of 1.2 mm and a card insertion guide part 4702 with a thickness of 0.6 mm.

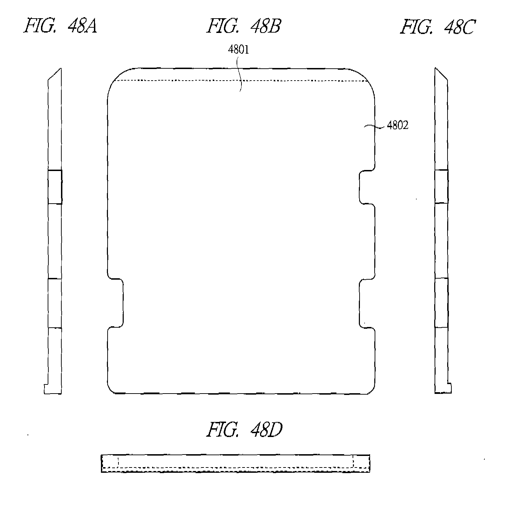

FIG. 48 is a view showing the outer shape of a M2 memory card according to a twentieth embodiment of the present invention, and FIG. 48A is a left side view, FIG. 48B is a plan view, FIG. 48C is a right side view, and FIG. 48D is a front view. As shown in FIG. 48, the M2 memory card according to the twentieth embodiment is constituted of a part 4801 having the same thickness as the card insertion guide part 4802 with a thickness of 0.6 mm. With this configuration, the same memory card socket as that for the ordinary M2 can be used, and moreover, a total thickness at the time of being mounted in the Plug-in SIM adaptor according to the above-described embodiments can be reduced.

### (Twenty-first Embodiment)

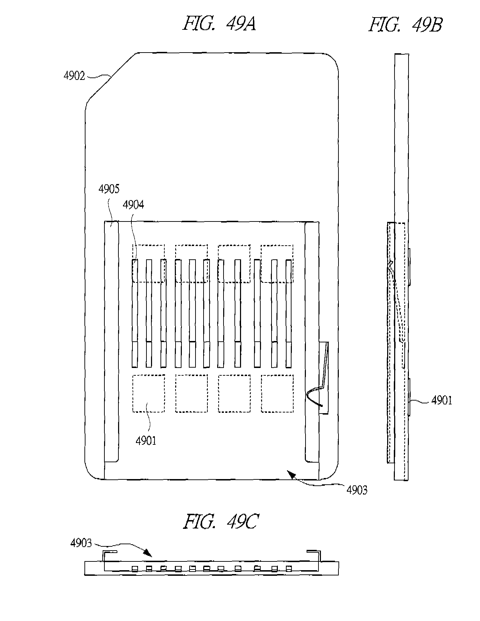

FIG. 49 is a full view showing the structure of the partly thick Plug-in SIM adaptor (for M2) according to a twenty-first embodiment of the present invention, and FIG. 49A is a plan view, FIG. 49B is a right side view, and FIG. 49C is a front view. As shown in FIG. 49, IS07816 electrodes 4901 are arranged on one of the surfaces (rear side of FIG. 49A) of the partly thick Plug-in SIM adaptor according to the twenty-first embodiment of the present invention. Further, a chamfered part 4902 is provided at one of the four corners. Further, a plurality of connecter terminals 4904 for contacting the terminals of the M2 memory card so as to make electrical connection are arranged inside a slot 4903 for storing a M2 memory card. Further, memory card retainers 4905 for fixing the M2 memory card are provided at both ends of the slot 4903. The Plug-in SIM adaptor according to the twenty-first embodiment has approximately the same shape and dimensions as those of the Plug-in SIM adaptors according to the eighteenth and nineteenth embodiments.

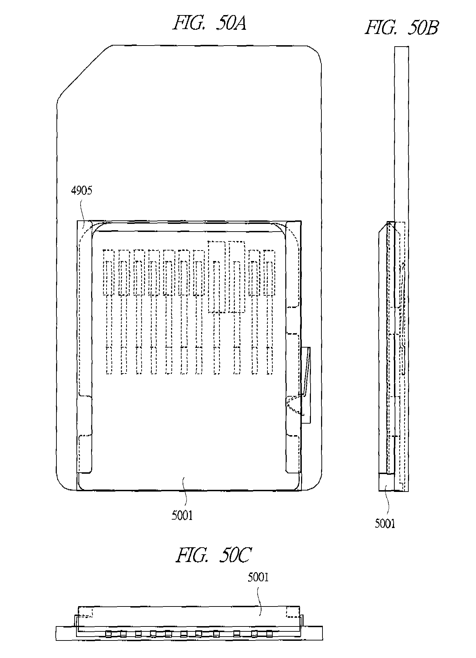

FIG. 50 is a full view showing a state after the ordinary M2 memory card is inserted into the partly thick Plug-in SIM adaptor according to the twenty-first embodiment of the present invention, and FIG. 50A is a plan view, FIG. 50B is a right side view, and FIG. 50C is a front view. As shown in FIG. 50, the ordinary M2 memory card 5001 shown in FIG. 47 is inserted into the slot of the Plug-in SIM adaptor, and the card insertion guide part 4702 is retained by the memory card retainer 4905, so that the M2 memory card 5001 is fixed.

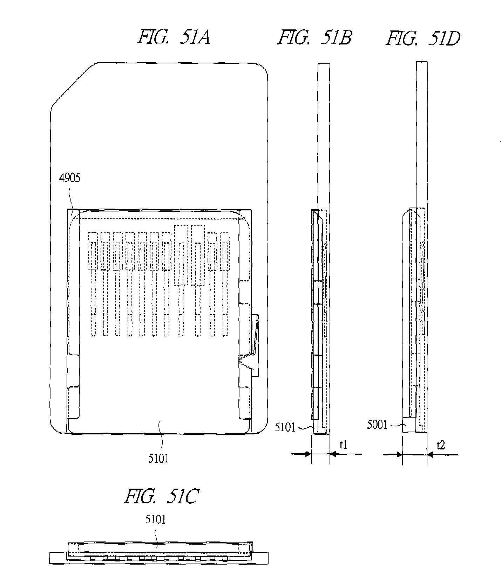

FIG. 51 is a full view showing a state after the M2 memory card according to the twentieth embodiment is inserted into the partly thick Plug-in SIM adaptor according to the twenty-first embodiment of the present invention, and FIG. 51A is a plan view, FIG. 51B is a right side view, FIG. 51C is a front view, and FIG. 51D is a right side view showing the state after the ordinary M2 memory card is inserted for comparison. As shown in FIG. 51, the M2 memory card 5101 according to the twentieth embodiment shown in FIG. 48 is inserted into the slot of the Plug-in SIM adaptor, and the card insertion guide part 4802 is retained by the memory card retainer 4905, so that the M2 memory card 5101 is fixed. The thickness of the Plug-in SIM adapter after the M2 memory card is inserted becomes t1 as shown in FIG. 51B after the M2 memory card 5101 (approximately 0.6 mm in thickness) according to the twentieth embodiment is inserted, and becomes t2 as shown in FIG. 51D after the ordinary M2 memory card 5001 (approximately 1.2 mm in thickness) is inserted. Note that t1<t2.

When the M2 memory card 5101 with a thickness of 0.6 mm according to the twentieth embodiment is inserted into the Plug-in SIM adaptor for the M2 memory card, the card insertion guide part 4802 of the M2 memory card has the same thickness as that of the card insertion guide part 4702, and the M2 memory card 5101 can be inserted in the same manner as the ordinary M2 memory card 5001. The thickness (t1) of the Plug-in SIM adaptor after the insertion becomes smaller compared with the thickness (t2) when the ordinary M2 memory card is inserted because a portion which is higher than the card retainer part of the Plug-in SIM adaptor does not exist. Note that the memory card retainer 4905 may have the structure covering the whole memory card.

### (Twenty-second Embodiment)

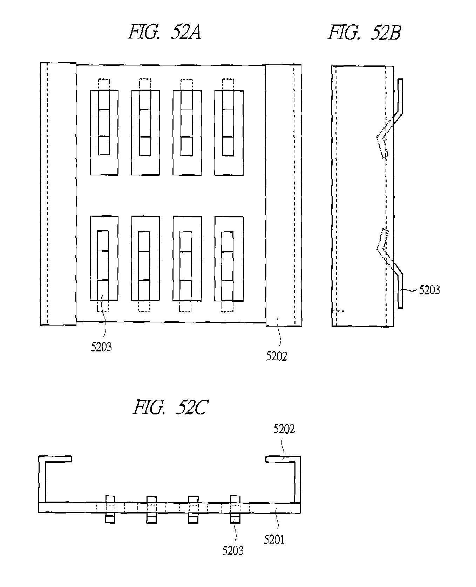

FIG. 52 is a full view of an IC card socket according to a twenty-second embodiment of the present invention, and FIG. 52A is a plan view, FIG. 52B is a right side view, and FIG. 52C is a front view. An IC card socket according to the twenty-second embodiment is constituted of, for example, a substrate 5201, card retainers 5202 provided on both sides of the substrate 5201, a plurality of contacts 5203 attached to the central hole part of the substrate, and the like. The card retainer 5202 is used for retaining and fixing an IC card such as the Plug-in SIM card and the Plug-in SIM adaptor according to the above-described embodiments. The contacts 5203 are brought into contact with ISO7816 electrodes provided in the Plug-in SIM card and the Plug-in SIM adaptor according to the above-described embodiments, thereby making electrical connection thereto.

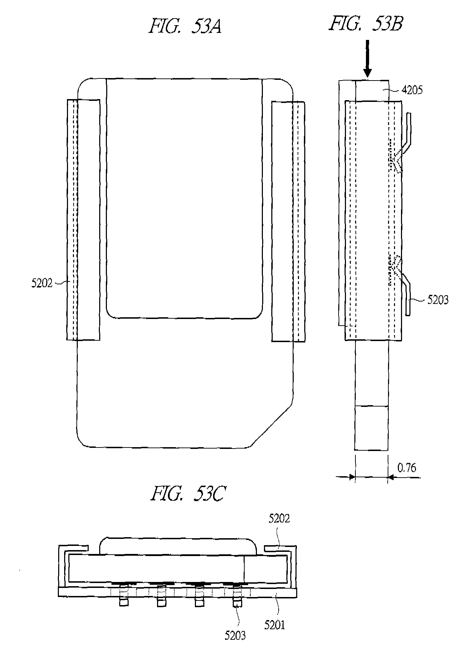

FIG. 53 is a full view showing a state after the partly thick Plug-in SIM adaptor (or card) is inserted into the IC card socket according to the twenty-second embodiment of the present invention, and FIG. 53A is a plan view, FIG. 53B is a right side view, and FIG. 53C is a front view. In FIG. 53, the Plug-in SIM adaptor 4205 according to the nineteenth embodiment is shown as one example of the IC card to be inserted, but it may be the Plug-in SIM card according to the seventeenth embodiment and the Plug-in SIM adaptors according to the eighteenth and twenty-first to the twenty-second embodiments.

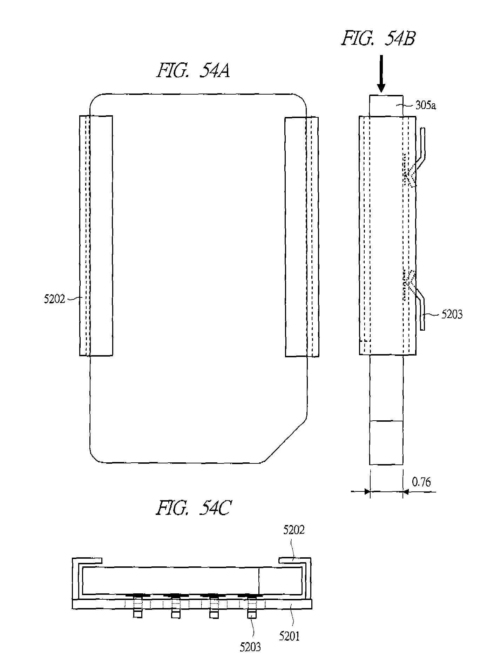

FIG. 54 is a full view showing a state after the Plug-in SIM adaptor (or card) with a thickness of 0.76 mm is inserted into the IC card socket according to the twenty-second embodiment of the present invention, and FIG. 54A is a plan view, FIG. 54B is a right side view, and FIG. 54C is a front view. In FIG. 54, the Plug-in SIM adaptor 305a according to the first embodiment is shown as one example of the IC card to be inserted, but it may be the conventional Plug-in SIM card and the like.

In order to mount a micro SD card, a M2 memory card and others, as a part to be thickened in the Plug-in SIM adaptor (or card), an area not interfering with a card retainer part is made thick, and the card retainer part is made to have the same thickness as the conventional Plug-in SIM card (0.76 mm), so that a common socket usable not only for the conventional Plug-in SIM card but also for the Plug-in SIM adaptor (or card) according to the above-described embodiments can be realized.

Note that the above-described embodiments may be appropriately combined.

In the foregoing, the invention made by the inventors of the present invention has been concretely described based on the embodiments. However, it is needless to say that the present invention is not limited to the foregoing embodiments and various modifications and alterations can be made within the scope of the present invention.

### INDUSTRIAL APPLICABILITY

The present invention can be utilized in the manufacturing industry of IC cards, electronic equipment, and the like.

## Claims

1. An IC card mounted with a flash memory chip,
wherein the IC card can be inserted into a Plug-in SIM adaptor and/or a mini UICC adaptor,
the IC card is inserted into the Plug-in SIM adaptor or the mini UICC adaptor, so that the Plug-in SIM adaptor or the mini UICC adaptor and the IC card are integrated to operate as a SIM attached with an expansion memory or a mini UICC attached with an expansion memory, and
the IC card can be physically removed from the Plug-in SIM adaptor or the mini UICC adaptor.

2. The IC card according to claim 1 further comprising:
a plurality of connecter terminals; and
the flash memory chip,
wherein, when inserted into the Plug-in SIM adaptor or the mini UICC adaptor, the connecter terminals are electrically connected to the SIM adaptor or the mini UICC adaptor.

3. The IC card according to claim 2 further comprising:
a controller chip for controlling the flash memory chip.

4. The IC card according to claim 3,
wherein the Plug-in SIM adaptor and the mini UICC adaptor include secure IC chips having a security microcomputer function.

5. The IC card according to claim 4,
wherein the secure IC chips are embedded in substrates of the Plug-in SIM adaptor and the mini UICC adaptor.

6. The IC card according to claim 3,
wherein the flash memory chip and the controller chip are covered with a mold.

7. The IC card according to claim 2 further comprising:
a secure IC chip having a security microcomputer function.

8. The IC card according to claim 1,
wherein a thickness of the IC card is smaller than that of the SIM adaptor.

9. The IC card according to claim 8,
wherein a thickness of the IC card is 0.84 mm or smaller.

10. The IC card according to claim 1,
wherein planar dimensions of the SIM adaptor are 15 mm × 25 mm, and planar dimensions of the mini UICC adaptor are 15 mm × 12 mm.

11. The IC card according to claim 1,
wherein the IC card can be converted into an interface of a memory stick PRO, a SD card, a multimedia card, a USB, a TCP/IP, an I²C or a serial interface communication (SCI).

12. The IC card according to claim 1 further comprising:
a plurality of first connecter terminals and a plurality of second connecter terminals,
wherein the first connecter terminals are terminals used for a first interface with the Plug-in SIM or the mini UICC, and
the second connecter terminals are terminals used for a second interface with a memory stick PRO, a SD card, a multimedia card, a USB, a TCP/IP, an I²C or a serial interface communication (SCI).

13. The IC card according to claim 12,
wherein protocols of the first interface and the second interface are different in whole or in part.

14. The IC card according to claim 1,
wherein the IC card and the Plug-in SIM adaptor or the mini UICC adaptor perform mutual device authentication, and only when the authentication is completed, the IC card functions as an additional memory of the Plug-in SIM or the mini UICC.

15. The IC card according to claim 14,
wherein the authentication of the IC card conforms to use of a memory stick PRO, a MMC or a SD card.

16. The IC card according to claim 14,
wherein an APDU conforming to an ISO/IEC7816 of a smart card is used in the authentication of the IC card.

17. An IC card which is mounted with a secure IC chip having a security microcomputer function and operates as a SIM,
wherein a flash memory card mounted with a flash memory chip can be inserted into the IC card, and
the flash memory card can be physically removed from the IC card.

18. The IC card according to claim 17,
wherein the flash memory card is inserted into the IC card, so that the flash memory card and the IC card are integrated to operate as a SIM attached with an expansion memory.

19. The IC card according to claim 17 further comprising:
a substrate mounted with the secure IC chip;
a module area in which the secure IC chip on the substrate is sealed; and
a slot for inserting the flash memory card,
wherein a plurality of connecter terminals for electrically connecting to the flash memory card are arranged in the slot.

20. The IC card according to claim 19,
wherein the secure IC chip is arranged on a chamfered part side with respect to a position of the slot.

21. The IC card according to claim 17,
wherein planar dimensions of the IC card are 15 mm × 25 mm.

22. The IC card according to claim 21,
wherein a thickness of the IC card is 0.84 mm or smaller.

23. An IC card which is mounted with a secure IC chip having a security microcomputer function and operates as a mini UICC,
wherein a flash memory card mounted with a flash memory chip can be inserted into the IC card, and
the flash memory card can be physically removed from the IC card.

24. The IC card according to claim 23,
wherein the flash memory card is inserted into the IC card, so that the flash memory card and the IC card are integrated to operate as a mini UICC attached with an expansion memory.

25. The IC card according to claim 24 further comprising:
a substrate in which the secure IC chip is incorporated; and
a slot for inserting the flash memory card,
wherein a plurality of connecter terminals for electrically connecting with the flash memory card are arranged in the slot.

26. The IC card according to claim 23,
wherein planar dimensions of the IC card are 15 mm × 12 mm.

27. The IC card according to claim 26,
wherein a thickness of the IC card is 0.84 mm or smaller.

28. An IC card which is mounted with a secure IC chip having a security microcomputer function and operates as a SIM, comprising:
a first part having a first thickness; and
a second part thicker than the first thickness provided on an inner side of the first part.

29. The IC card according to claim 28,
wherein the first thickness is 0.76 mm.

30. The IC card according to claim 28,
wherein a crystal oscillator is mounted inside the second part.

31. The IC card according to claim 28,
wherein stacked memory chips are mounted inside the second part.

32. The IC card according to claim 28,
wherein the IC card has a slot inside the second part, and a memory card mounted with a memory chip can be inserted into the slot, and
the memory card can be physically removed from the IC card.

33. The IC card according to claim 32,
wherein the memory card is inserted into the IC card, so that the memory card and the IC card are integrated to operate as a SIM attached with an expansion memory.

34. The IC card according to claim 33,
wherein the memory card is a micro SD card or a M2 memory card.

35. An IC card socket into which a first IC card including a first part having a first thickness and a second part thicker than the first thickness provided on an inner side of the first part and a second IC card including a third part having the first thickness and a fourth part having the first thickness provided on an inner side of the third part can be inserted in common,
wherein the IC card socket includes a card retainer having a height capable of fixing the first IC card and the second IC card by retaining the first part and the third part and having a width not in contact with the second part.

36. The IC card socket according to claim 35,
wherein the first thickness is 0.76 mm.
